# EUROPEAN PATENT APPLICATION

(11) **EP 4 415 046 A1**
(43) Date of publication of application: **14.08.2024**
(21) Application number: 24155138.1
(22) Date of filing: 31.01.2024
(51) Int. Cl.: H01L 25/075, H01L 33/50

(54) **WHITE LED PACKAGE FOR VIRTUAL REALITY LIQUID CRYSTAL DISPLAY**

(30) Priority: 13.02.2023 US 202363445255 P; 11.03.2023 US 202363489754 P; 24.01.2024 US 202418421942
(71) Applicant: Meta Platforms Technologies, LLC, Menlo Park, CA 94025 (US)
(72) Inventor: Ye, Shenglin, Menlo Park (US); Zhu, Xinyu, Menlo Park (US); Li, Xiangtong, Menlo Park (US); Ma, Ruiqing, Menlo Park (US); Wang, Yu-Jen, Menlo Park (US); Lee, Yun-Han, Menlo Park (US); Rao, Linghui, Menlo Park (US); Hallstein, Sascha, Menlo Park (US)
(74) Representative: Murgitroyd & Company

(57) **Abstract**

A light-emitting diode ("LED") package includes a package housing defining a space. The LED package includes a first LED disposed with the space defined by the package housing, and configured to emit a first light having a blue wavelength range. The blue wavelength range has a peak wavelength ranging from about 440 nm to about 480 nm. The LED package includes a second LED disposed within the space, and configured to emit a second light having a red wavelength range. The red wavelength range has a peak wavelength ranging from about 610 nm to about 680 nm. The LED package includes a phosphor filler filling the space and configured to absorb a portion of the first light to emit a third light having a green wavelength range. The green wavelength range has a peak wavelength ranging from about 510 nm to about 570 nm.

## Description

### TECHNICAL FIELD

The present disclosure relates generally to optical devices and fabrication methods and, more specifically, to a white light-emitting diode ("LED") package for virtual reality liquid crystal display.

### BACKGROUND

Display technologies have been widely used in a large variety of applications in daily life, such as smartphones, tablets, laptops, monitors, TVs, projectors, vehicles, virtual reality ("VR") devices, augmented reality ("AR") devices, mixed reality ("MR") devices, etc. Non-emissive displays, such as liquid crystal displays ("LCDs"), liquid-crystal-on-silicon ("LCoS") displays, or digital light processing ("DLP") displays, may require a backlight unit to illuminate a display panel. Self-emissive displays may display images through emitting lights with different intensities and colors from light-emitting elements. A self-emissive display may also function as a locally dimmable backlight unit for a non-emissive display panel. A compact display engine with dynamic zonal brightness control with improved display performance and power budget is highly desirable, which can be incorporated into a variety of devices, and is suitable for portable devices including hand-held, wrist-worn, or head-mounted devices, etc.

### SUMMARY OF THE DISCLOSURE

Consistent with an aspect of the present disclosure, a light-emitting diode ("LED") package is provided. The LED package includes a first LED disposed with the space defined by the package housing, and configured to emit a first light having a blue wavelength range. The blue wavelength range has a peak wavelength ranging from about 440 nm to about 480 nm. The LED package further includes a second LED disposed within the space, and configured to emit a second light having a red wavelength range. The red wavelength range has a peak wavelength ranging from about 610 nm to about 680 nm. The LED package further includes a phosphor filler filling the space and configured to absorb a portion of the first light to emit a third light having a green wavelength range. The green wavelength range has a peak wavelength ranging from about 510 nm to about 570 nm.

In accordance with an aspect of the present disclosure, there is provided a light-emitting diode ("LED") package, comprising: a package housing defining a space; a first LED disposed with the space defined by the package housing, and configured to emit a first light having a blue wavelength range, wherein the blue wavelength range has a peak wavelength ranging from about 440 nm to about 480 nm; a second LED disposed within the space defined by the package housing, and configured to emit a second light having a red wavelength range, wherein the red wavelength range has a peak wavelength ranging from about 610 nm to about 680 nm; an a phosphor filler filling the space and configured to absorb a portion of the first light to emit a third light having a green wavelength range, wherein the green wavelength range has a peak wavelength ranging from about 510 nm to about 570 nm.

In some embodiments, the first LED and the second LED are configured to be individually or independently drivable by individual driving circuits.

In some embodiments, the LED package further comprises a controller configured to individually control driving currents provided by the driving circuits to the first LED and the second LED to adjust a color of an output light of the LED package.

In some embodiments, a concentration of the phosphor filler is adjustable to adjust a color of an output light of the LED package.

In some embodiments, the LED package further comprises a third LED disposed inside the package housing, and configured to emit the first light having the blue wavelength range, wherein the blue wavelength range has the peak wavelength ranging from about 440 nm to about 480 nm.

In some embodiments, the first LED and the third LED are connected in series, and are configured to be drivable by a same driving circuit.

In some embodiments, the driving currents provided to the first LED and the second LED are the same, or are different.

In some embodiments, the second LED is disposed between the first LED and the third LED.

In some embodiments, the first LED and the third LED are disposed side by side along a first row, the second LED is disposed along a second row, and the second row is parallel with the first row or the same as the first row.

In some embodiments, the first LED, the second LED, and the third LED are disposed side by side along a same row.

In some embodiments, the second LED has a size that is greater than the first LED.

In some embodiments, the LED package, further comprises a fourth LED disposed inside the package housing, and configured to emit the second light having the red wavelength range with the peak wavelength ranging from about 610 nm to about 680 nm.

In some embodiments, the first LED and the third LED are connected in series and are configured to be drivable by a first driving circuit, and the second LED and the fourth LED are connected in series and are configured to be drivable by a second, different driving circuit, and wherein the LED package further includes a controller configured to individually control driving currents provided by the first and second driving circuits to adjust a color of an output light of the LED package.

In some embodiments, the first LED and the third LED are blue LEDs, and the second LED and the fourth LED are red LEDs, and the blue LEDs and the red LEDs are arranged in an alternating pattern.

In some embodiments, the first LED and the third LED are arranged side by side along a first row, and the second LED and the fourth LED are arranged side by side along a second row, the second row is parallel with the first row.

In some embodiments, the first LED, the second LED, the third LED, and the fourth LED are arranged side by side along a same row.

In some embodiments, the LED package, further comprises a third LED disposed inside the package housing, and configured to emit the second light having the red wavelength range with the peak wavelength ranging from about 610 nm to about 680 nm.

It will be appreciated that any features described herein as being suitable for incorporation into one or more aspects or embodiments of the present disclosure are intended to be generalizable across any and all aspects and embodiments of the present disclosure. Other aspects of the present disclosure can be understood by those skilled in the art in beam of the description, the claims, and the drawings of the present disclosure. The foregoing general description and the following detailed description are exemplary and explanatory only and are not restrictive of the claims.

### BRIEF DESCRIPTION OF THE DRAWINGS

The following drawings are provided for illustrative purposes according to various disclosed embodiments and are not intended to limit the scope of the present disclosure. In the drawings:
FIGs. 1A and 1B illustrate schematic diagrams of a conventional white LED package;
FIGs. 2A and 2B illustrate schematic diagrams of a white LED package, according to an embodiment of the present disclosure;
FIG. 2C illustrates a schematic diagram of driving circuits of the white LED package shown in FIGs. 2A and 2B, according to an embodiment of the present disclosure;
FIGs. 3A and 3B illustrate schematic diagrams of a white LED package, according to an embodiment of the present disclosure;
FIG. 3C illustrates a schematic diagram of driving circuits of the white LED package shown in FIGs. 3A and 3B, according to an embodiment of the present disclosure;
FIGs. 4A and 4B illustrate schematic diagrams of a white LED package, according to an embodiment of the present disclosure;
FIG. 4C illustrates a schematic diagram of driving circuits of the white LED package shown in FIGs. 4A and 4B, according to an embodiment of the present disclosure;
FIGs. 5A and 5B illustrate schematic diagrams of a white LED package, according to an embodiment of the present disclosure;
FIG. 5C illustrates a schematic diagram of driving circuits of the white LED package shown in FIGs. 5A and 5B, according to an embodiment of the present disclosure;
FIGs. 6A and 6B illustrate schematic diagrams of a white LED package, according to an embodiment of the present disclosure;
FIG. 6C illustrates a schematic diagram of driving circuits of the white LED package shown in FIGs. 6A and 6B, according to an embodiment of the present disclosure;
FIGs. 7A-7C illustrate schematic diagrams of a white LED package, according to an embodiment of the present disclosure;
FIGs. 8A and 8B illustrate schematic diagrams of a white LED package, according to an embodiment of the present disclosure;
FIG. 8C illustrates a schematic diagram of driving circuits of the white LED package shown in FIGs. 8A and 8B, according to an embodiment of the present disclosure;
FIGs. 9A and 9B illustrate schematic diagrams of a white LED package, according to an embodiment of the present disclosure;
FIG. 9C illustrates a schematic diagram of driving circuits of the white LED package shown in FIGs. 9A and 9B, according to an embodiment of the present disclosure;
FIGs. 10A-10C illustrate schematic diagrams of a white LED package, according to an embodiment of the present disclosure;
FIG. 11A illustrates a schematic diagram of a display system, according to an embodiment of the present disclosure;
FIG. 11B illustrates a schematic diagram of an illuminator that may be included in the display system shown in FIG. 11A, according to an embodiment of the present disclosure;
FIG. 11C illustrates a schematic diagram of a display system, according to an embodiment of the present disclosure;
FIG. 12A illustrates a schematic diagram of an artificial reality device, according to an embodiment of the present disclosure;
FIG. 12B schematically illustrates a cross-sectional view of half of the artificial reality device shown in FIG. 12A, according to an embodiment of the present disclosure; and
FIG. 12C schematically illustrates a cross-sectional view of the artificial reality device shown in FIG. 12A, according to an embodiment of the present disclosure.

### DETAILED DESCRIPTION

Embodiments consistent with the present disclosure will be described with reference to the accompanying drawings, which are merely examples for illustrative purposes and are not intended to limit the scope of the present disclosure. Wherever possible, the same reference numbers are used throughout the drawings to refer to the same or similar parts, and a detailed description thereof may be omitted.

Further, in the present disclosure, the disclosed embodiments and the features of the disclosed embodiments may be combined. The described embodiments are some but not all of the embodiments of the present disclosure. Based on the disclosed embodiments, persons of ordinary skill in the art may derive other embodiments consistent with the present disclosure. For example, modifications, adaptations, substitutions, additions, or other variations may be made based on the disclosed embodiments. Such variations of the disclosed embodiments are still within the scope of the present disclosure. Accordingly, the present disclosure is not limited to the disclosed embodiments. Instead, the scope of the present disclosure is defined by the appended claims.

As used herein, the terms "couple," "coupled," "coupling," or the like may encompass an optical coupling, a mechanical coupling, an electrical coupling, an electromagnetic coupling, or any combination thereof. An "optical coupling" between two optical elements refers to a configuration in which the two optical elements are arranged in an optical series, and a light output from one optical element may be directly or indirectly received by the other optical element. An optical series refers to optical positioning of a plurality of optical elements in a light path, such that a light output from one optical element may be transmitted, reflected, diffracted, converted, modified, or otherwise processed or manipulated by one or more of other optical elements. In some embodiments, the sequence in which the plurality of optical elements are arranged may or may not affect an overall output of the plurality of optical elements. A coupling may be a direct coupling or an indirect coupling (e.g., coupling through an intermediate element).

The phrase "at least one of A or B" may encompass all combinations of A and B, such as A only, B only, or A and B. Likewise, the phrase "at least one of A, B, or C" may encompass all combinations of A, B, and C, such as A only, B only, C only, A and B, A and C, B and C, or A and B and C. The phrase "A and/or B" may be interpreted in a manner similar to that of the phrase "at least one of A or B." For example, the phrase "A and/or B" may encompass all combinations of A and B, such as A only, B only, or A and B. Likewise, the phrase "A, B, and/or C" has a meaning similar to that of the phrase "at least one of A, B, or C." For example, the phrase "A, B, and/or C" may encompass all combinations of A, B, and C, such as A only, B only, C only, A and B, A and C, B and C, or A and B and C.

When a first element is described as "attached," "provided," "formed," "affixed," "mounted," "secured," "connected," "bonded," "recorded," or "disposed," to, on, at, or at least partially in a second element, the first element may be "attached," "provided," "formed," "affixed," "mounted," "secured," "connected," "bonded," "recorded," or "disposed," to, on, at, or at least partially in the second element using any suitable mechanical or non-mechanical manner, such as depositing, coating, etching, bonding, gluing, screwing, press-fitting, snap-fitting, clamping, etc. In addition, the first element may be in direct contact with the second element, or there may be an intermediate element between the first element and the second element. The first element may be disposed at any suitable side of the second element, such as left, right, front, back, top, or bottom.

When the first element is shown or described as being disposed or arranged "on" the second element, term "on" is merely used to indicate an example relative orientation between the first element and the second element. The description may be based on a reference coordinate system shown in a figure, or may be based on a current view or example configuration shown in a figure. For example, when a view shown in a figure is described, the first element may be described as being disposed "on" the second element. It is understood that the term "on" may not necessarily imply that the first element is over the second element in the vertical, gravitational direction. For example, when the assembly of the first element and the second element is turned 180 degrees, the first element may be "under" the second element (or the second element may be "on" the first element). Thus, it is understood that when a figure shows that the first element is "on" the second element, the configuration is merely an illustrative example. The first element may be disposed or arranged at any suitable orientation relative to the second element (e.g., over or above the second element, below or under the second element, left to the second element, right to the second element, behind the second element, in front of the second element, etc.).

When the first element is described as being disposed "on" the second element, the first element may be directly or indirectly disposed on the second element. The first element being directly disposed on the second element indicates that no additional element is disposed between the first element and the second element. The first element being indirectly disposed on the second element indicates that one or more additional elements are disposed between the first element and the second element.

The term "processor" used herein may encompass any suitable processor, such as a central processing unit ("CPU"), a graphics processing unit ("GPU"), an application-specific integrated circuit ("ASIC"), a programmable logic device ("PLD"), or any combination thereof Other processors not listed above may also be used. A processor may be implemented as software, hardware, firmware, or any combination thereof.

The term "controller" may encompass any suitable electrical circuit, software, or processor configured to generate a control signal for controlling a device, a circuit, an optical element, etc. A "controller" may be implemented as software, hardware, firmware, or any combination thereof. For example, a controller may include a processor, or may be included as a part of a processor.

A liquid crystal display ("LCD") used in a virtual reality device (or virtual reality-liquid crystal display ("VR-LCD")) often incorporates white light-emitting diode ("LED") packages within its backlight unit ("BLU") to produce a white light to illuminate an LCD panel. Conventional white LED packages in the BLU may rely on Yttrium Aluminum Garnet ("YAG") LEDs or Nitride LEDs, which can only achieve a standard red, green, blue ("sRGB") color gamut (that covers about 72% of the National Television System Committee ("NTSC") gamut). To achieve a DCI-P3 color gamut (that covers 26% more color space than sRGB color gamut), blue LEDs and quantum dot color conversion sheets may be needed in the BLU.

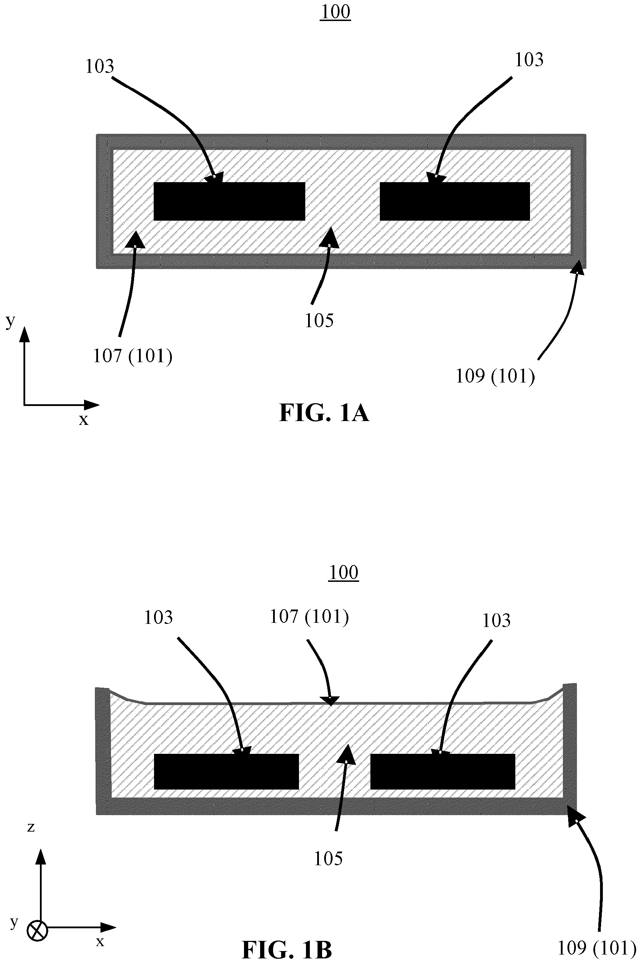

FIGs. 1A and 1B illustrate schematic diagrams of a conventional white LED package 100. FIG. 1A illustrates a top view (e.g., an x-y sectional view) of the white LED package 100, and FIG. 1B illustrates a side view (e.g., an x-z sectional view) of the white LED package 100. As shown in FIGs. 1A and 1B, the white LED package 100 may include blue LEDs 103 (e.g., two blue LEDs) and a phosphor filler 105 surrounding the blue LEDs 103. The blue LEDs 103 and the phosphor filler 105 may be enclosed by a package wall 101, which may form the outer casing of the white LED package 100 and may provide mechanical protection, electrical insulation, and environmental resistance. The package wall 101 may include a first portion 109 that is optically opaque, and a second portion 107 that is optically transparent. The optically transparent portion 107 of the package wall 101 may be a light emission window 107 (that may be located within an x-y plane), through which a generated white light exits the white LED package 100.

The conventional white LED package 100 may be a conventional YAG LED package, where the phosphor filler 105 includes a YAG phosphor (that is a yellow phosphor). The YAG phosphor may absorb a blue light emitted from the blue LEDs 103 to emit a yellow light, which may be mixed with the blue light emitted from the blue LEDs 103 to generate a white light.

The conventional white LED package 100 may be a conventional Potassium Fluorosilicate:Mn⁴⁺ ("KSF") LED or Calcium Aluminum Silicon Nitride ("CASN") LED package, in which the phosphor filler 105 may include a red phosphor and a green phosphor. The red phosphor may be a KSF phosphor or CASN phosphor that absorbs a blue light emitted from the blue LEDs 103 to emit a red light. The green phosphor may absorb a blue light emitted from the blue LEDs 103 to emit a green light. The red, green, and blue lights may be mixed to generate a white light.

VR-LCDs are often pulse driven, with a duty ratio of about 10%. For example, for a 90Hz LCD, the frame time of a display frame is about 11 milliseconds ("ms"). That is, the LEDs used in the BLU of the VR-LCD are only turned on for about 10% of the frame time (i.e., about 1.1 ms), and are turned off for the remaining frame time (i.e., about 10 ms). The conventional YAG LED package may generally exhibit a fast turn-on and turn-off speed, with a switching time of less than 1 ms. Although the conventional YAG LED package can be used in the BLU of the VR-LCD, only the sRGB color gamut may be achieved.

The conventional KSF LED package may possess a slower turn-on and turn-off speed, with a switching time exceeding 12 ms, rendering them unsuitable for use in the BLU of the VR-LCD. The conventional CASN LED package may feature fast turn-on and turn-off speeds, making them a potential candidate for the BLU of the VR-LCD. However, due to the broad spectrum of the red light generated by the red phosphor (i.e., the CASN photoshop) absorbing the blue light, the conventional CASN LED package may not be able to achieve the DCI-P3 color gamut. It is challenging to provide a satisfactory solution available for achieving the DCI-P3 color gamut in VR-LCDs.

Additionally, in conventional white LED packages, blue LEDs wired in series are connected end to end (e.g., the negative electrode of the first LED is connected to the positive electrode of the second LED, and so on), and the driving currents of the blue LEDs are the same. Thus, adjusting the color, such as the white point, of the emitted white light from the conventional white LED packages may be challenging or limited.

In view of the limitations of the conventional technologies, the present disclosure provides a white LED package that achieves the DCI-P3 color gamut and reduces the LED cost adder. The white LED package may have potential applications in the BLU of VR-LCDs. In the following, various white LED packages that achieve the DCI-P3 color gamut will be explained. The design principle and driving mechanism of the disclosed white LED packages may be applied to other suitable light-emitting element package for generating a white light and achieving the DCI-P3 color gamut.

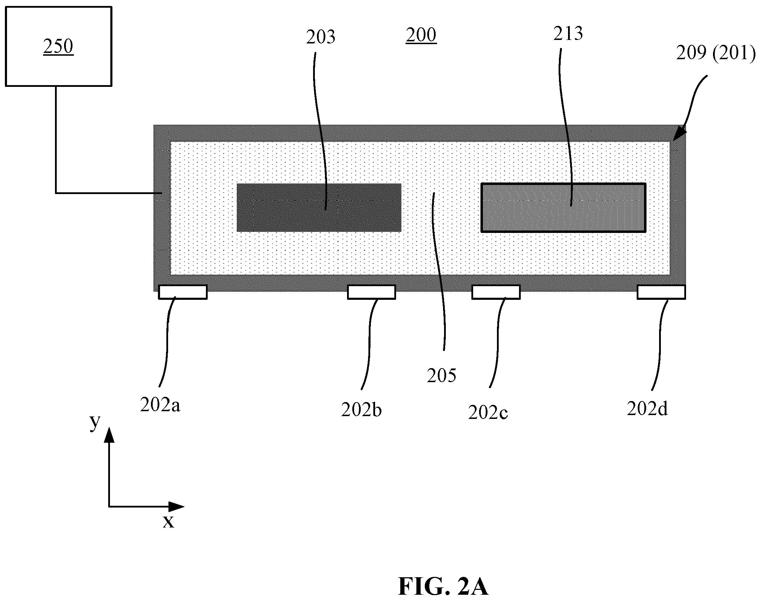

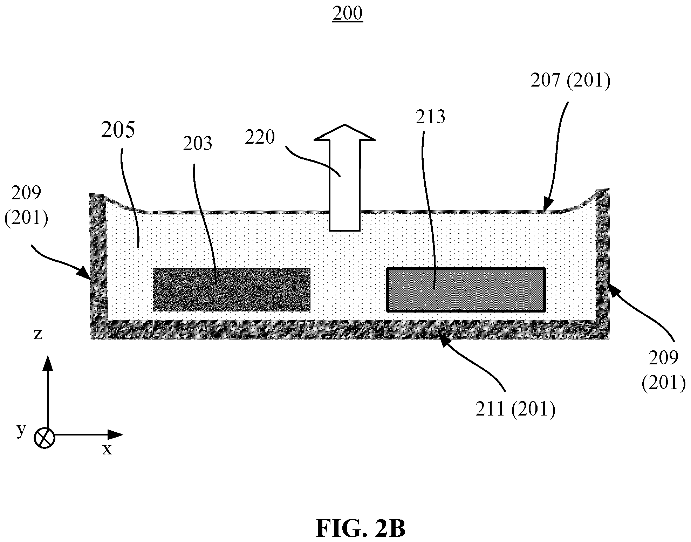

FIGs. 2A and 2B illustrate schematic diagrams of a white LED package 200, according to an embodiment of the present disclosure. FIG. 2A illustrates a top view (e.g., an x-y sectional view) of the white LED package 200, and FIG. 2B illustrates a side view (e.g., an x-z sectional view) of the white LED package 200. As shown in FIGs. 2A and 2B, the white LED package 200 may include a package housing (or package wall) 201 defining a space that accommodate a blue LED 203, a red LED 213, and a green phosphor filler 205 disposed inside the package housing 201. The package housing 201 may form the outer casing of the white LED package 200 and provide mechanical protection, electrical insulation, and environmental resistance. In some embodiments, the package housing 201 may include a substrate 211, a side wall 209, and a light emission window 207 (e.g., located within an x-y plane) facing the substrate 211. In some embodiments, the substrate 211 and the side wall 209 may be optically opaque, and the light emission window 207 may be optically transparent, through which a generated white light exits the white LED package 200.

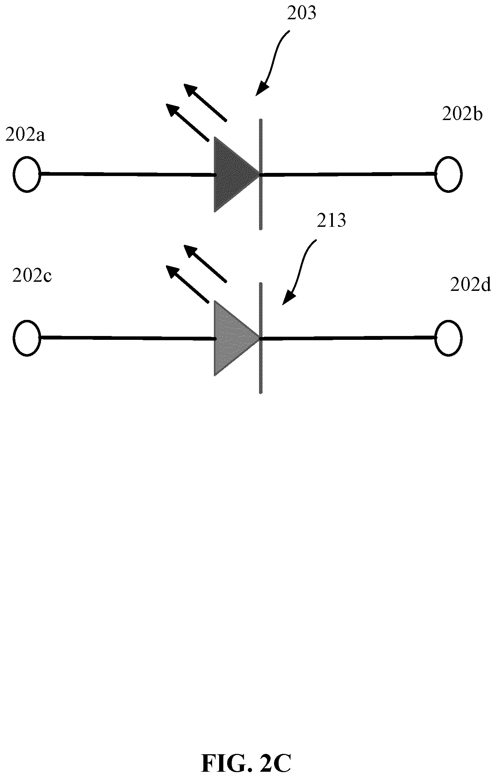

In some embodiments, the blue LED 203 and the red LED 213 may be disposed at the substate 211 (e.g., directly on or indirectly on the substrate 211), and the green phosphor filler 205 may be disposed at least partially over the blue LED 203 and the red LED 213. For discussion purposes, FIGs. 2A and 2B show that the green phosphor filler 205 is disposed surrounding the blue LED 203 and the red LED 213, and filling substantially the entire space defined by the packaging house 201. Each of the blue LED 203 and the red LED 213 may include a suitable type of LEDs, such as an LED, a mini LED, or a micro-LED ("µ-LED"), etc. The white LED package 200 may also include a plurality of electrodes, e.g., a first electrode 202a, a second electrode 202b, a third electrode 202c, and a fourth electrode 202d. The electrodes 202a-202d may be electrically connected to respective LED driving circuits (shown in FIG. 2C and described below). In some embodiments, the white LED package 200 may also include a controller 250 configured to individually control the respective LED driving circuits.

The blue LED 203 may be configured to emit a first light having a blue wavelength range with a peak wavelength ranging from about 440 nm to about 480 nm. The red LED 213 may be configured to emit a second light having a red wavelength range with a peak wavelength ranging from about 610 nm to about 680 nm. The green phosphor filler 205 may be configured to absorb at least a portion of the first light to emit a third light having a green wavelength range. The green wavelength range may have a peak wavelength ranging from about 510 nm to about 570 nm. For discussion purposes, in the following description, the first light having the blue wavelength range with the peak wavelength ranging from about 440 nm to about 480 nm may be referred to as a blue light, the second light having the red wavelength range with the peak wavelength ranging from about 610 nm to about 680 nm may be referred to as a red light, and the third light having the green wavelength range with the peak wavelength ranging from about 510 nm to about 570 nm may be referred to as a green light. The green phosphor filler 205 may not absorb the red light output from the red LED 213. The red light output from the red LED 213, the blue light output from the blue LED 203, and the green light output from the green phosphor filler 205 may be mixed to generate a white light 220 that exits the white LED package 200 through the light emission window 207.

The white LED package 200 may not include a red phosphor. The red light in the white LED package 200 may be directly emitted from the red LED 213, or directly generated by the red LED 213, rather than being emitted from a red phosphor that absorbs the blue light in the conventional KSF LED or CASN LED package. The red light directly emitted by the red LED 213 may have a narrower spectrum (or bandwidth) than the red light generated by a red phosphor absorbing the blue light in the conventional KSF LED or CASN LED package. Thus, the white LED package 200 may achieve the DCI-P3 color gamut. The white LED package 200 may be applied to edge-lit BLUs of VR-LCDs, for achieving the DCI-P3 color gamut.

FIG. 2C illustrates driving circuits of the white LED package 200, according to an embodiment of the present disclosure. As shown in FIG. 2C, the blue LED 203 and the red LED 213 may not be connected in series. The blue LED 203 and the red LED 213 may be individually or independently drivable. The blue LED 203 and the red LED 213 may have individual driving circuits, and the driving currents provided by the driving circuits to the blue LED 203 and the red LED 213 may be individually or independently adjustable via the controller 250. The driving currents provided to the blue LED 203 and the red LED 213 may be the same, or may be different.

For example, in the embodiment shown in FIG. 2C, the first electrode 202a and the second electrode 202b may be an anode and a cathode of the blue LED 203, respectively, which may be electrically connected to a first driving circuit. The third electrode 202c and the fourth electrode 202d may be an anode and a cathode of the red LED 213, respectively, which may be electrically connected to a second driving circuit that is different from the first driving circuit. In some embodiments, the cathode (e.g., second electrode 202b) of the blue LED 203 and the cathode (e.g., fourth electrode 202d) of the red LED 213 may be electrically connected, whereas the anode (e.g., first electrode 202a) of the blue LED 203 and the anode (e.g., third electrode 202c) of the red LED 213 may be separately connected to different driving circuits.

In the disclosed embodiment, a color (e.g., white point) of the white light 220 output from the white LED package 200 may be adjustable via adjusting the ratio of the red light output from the red LED 213, the blue light output from the blue LED 203, and the green light output from the green phosphor filler 205 in the white light 220. In some embodiments, the driving currents provided to the blue LED 203 and the red LED 213 may be individually adjustable, through which the ratio of the red light output from the red LED 213, the blue light output from the blue LED 203, and the green light output from the green phosphor filler 205 in the white light 220 may be adjustable. In some embodiments, the concentration of the phosphor filler may be adjustable, through which the ratio of the red light output from the red LED 213, the blue light output from the blue LED 203, and the green light output from the green phosphor filler 205 in the white light 220 may be adjustable. Accordingly, a color (e.g., white point) of the white light 220 output from the white LED package 200 may be adjustable.

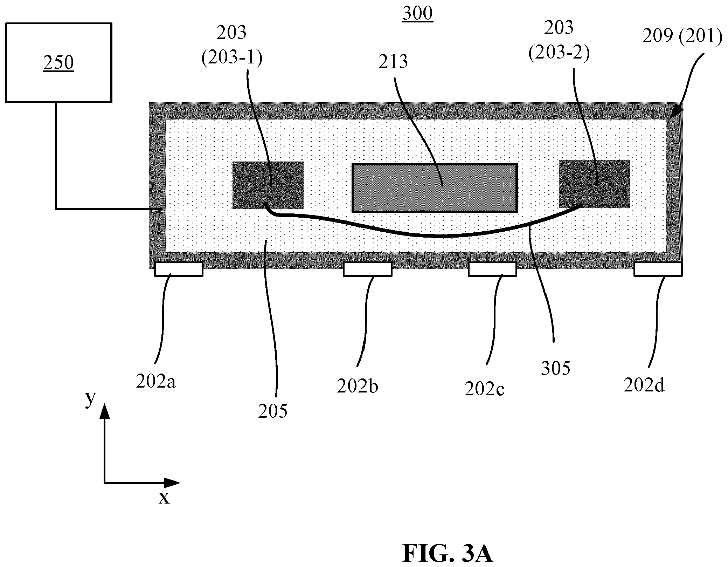

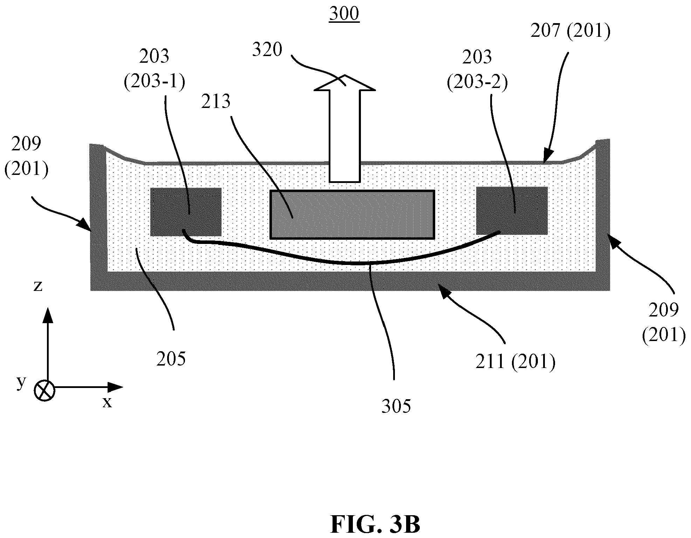

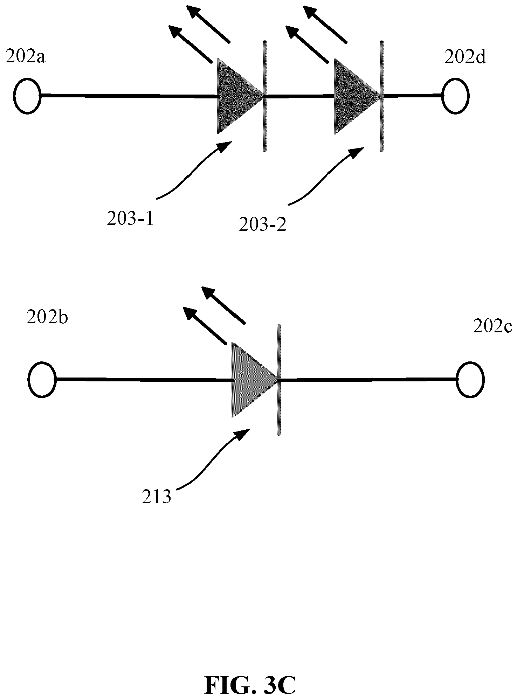

FIGs. 3A and 3B illustrate schematic diagrams of a white LED package 300, according to an embodiment of the present disclosure. FIG. 3A illustrates a top view (e.g., an x-y sectional view) of the white LED package 300, and FIG. 3B illustrates a side view (e.g., an x-z sectional view) of the white LED package 300. FIG. 3C illustrates driving circuits of the white LED package 300, according to an embodiment of the present disclosure. The white LED package 300 shown in FIGs. 3A-3C may include elements, structures, and/or functions that are the same as or similar to those included in the white LED package 200 shown in FIGs. 2A-2C. Descriptions of the same or similar elements, structures, and/or functions can refer to the above descriptions rendered in connection with FIGs. 2A-2C.

As shown in FIGs. 3A and 3B, the white LED package 300 may include the package housing (or package wall) 201 defining a space. The white LED package 300 may also include two blue LEDs 203-1 and 203-2 (collectively referred to as 203), the red LED 213, and the green phosphor filler 205 disposed inside the package housing 201 that may fill substantially the entire space defined by the package housing 201. In some embodiments, the two blue LEDs 203 and the red LED 213 may be disposed at the substate 211 (e.g., directly on or indirectly on the substrate 211), and the green phosphor filler 205 may be disposed at least partially over the blue LEDs 203 and the red LED 213. For discussion purposes, FIGs. 3A and 3B show that the green phosphor filler 205 is disposed surrounding the blue LEDs 203 and the red LED 213. The white LED package 300 may also include the electrodes 202a-202d that are electrically connected to respective LED driving circuits.

The red LED 213 may be configured to emit a red light. The blue LEDs 203 may be configured to emit a blue light. The green phosphor filler 205 may be configured to absorb at least a portion of the blue light emitted by the blue LEDs 203, and at least partially convert the absorbed blue light into a green light. The green phosphor filler 205 may not absorb the red light output from the red LED 213. The red light output from the red LED 213, the blue light output from the blue LEDs 203, and the green light output from the green phosphor filler 205 may be mixed to generate a white light 320, which exits the white LED package 300 through the light emission window 207.

In some embodiments, the two blue LEDs 203 and the red LED 213 may be aligned along a same row or line (e.g., in the x-y plane). In some embodiments, the red LED 213 may be disposed between the blue LED 203-1 and the blue LED 203-2. The blue LED 203-1 and the blue LED 203-2 may be electrically connected to one another via a connection wire 305. In some embodiments, the red LED 213 may have a size that is greater than the blue LEDs 203, e.g., the size of the red LED 213 may be two times of the size of each of the blue LEDs 203 (in some embodiments, the blue LEDs 203 may have the same size). The blue LEDs 203 and the red LED 213 may be individually or independently driven, e.g., via the controller 250. The electrically connected blue LED 203-1 and blue LED 203-2 may be driven in series, via a first driving circuit, while the red LED 213 may be driven separately, via a second, different driving circuit. The driving currents of the blue LEDs 203 and the red LED 213 may be individually or independently adjustable. Thus, the ratio of the red light output from the red LED 213, the blue light output from the blue LEDs 203, and the green light output from the green phosphor filler 205 in the white light 320 may be adjustable. Accordingly, a color (e.g., white point) of the white light 320 output from the white LED package 300 may be adjustable.

For example, in the embodiment shown in FIG. 3C, the first electrode 202a may be the anode of the blue LED 203-1, and the fourth electrode 202d may be the cathode of the blue LED 203-2, with the cathode of the blue LED 203-1 electrically connected to the anode of the blue LED 203-2 (thus, the blue LEDs 203-1 and 203-2 may be connected in series). The first electrode 202a and the fourth electrode 202d may be electrically connected to the first driving circuit for the blue LEDs 203. The second electrode 202b and the third electrode 202c may be the anode and the cathode of the red LED 213, respectively, which may be electrically connected to the second driving circuit. In some embodiments, the cathode (e.g., fourth electrode 202d) of the blue LED 203-2 and the cathode (e.g., third electrode 202c) of the red LED 213 may be electrically connected, whereas the anode (e.g., first electrode 202a) of the blue LED 203-1 and the anode (e.g., second electrode 202b) of the red LED 213 may be separately connected to different driving circuits.

In some embodiments, the concentration of the green phosphor filler 205 may be adjustable, through which the ratio of the red light output from the red LED 213, the blue light output from the blue LED 203, and the green light output from the green phosphor filler 205 in the white light 320 may be adjustable. Accordingly, a color (e.g., white point) of the white light 320 output from the white LED package 200 may be adjustable.

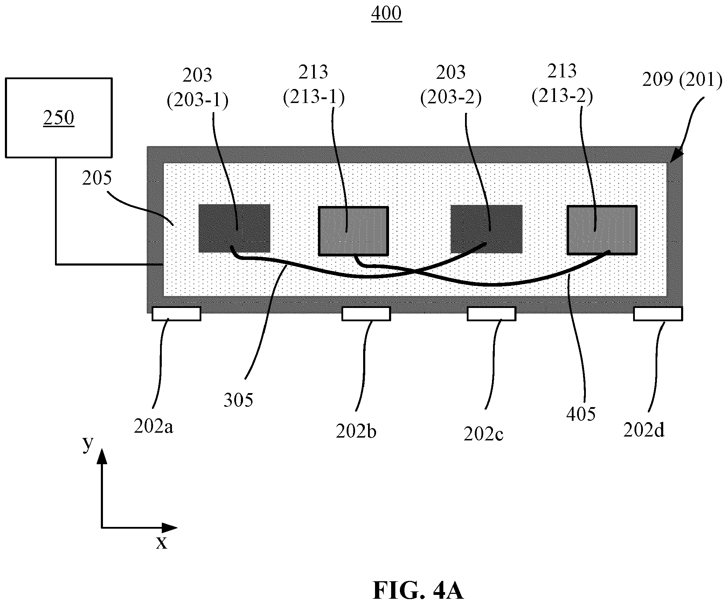

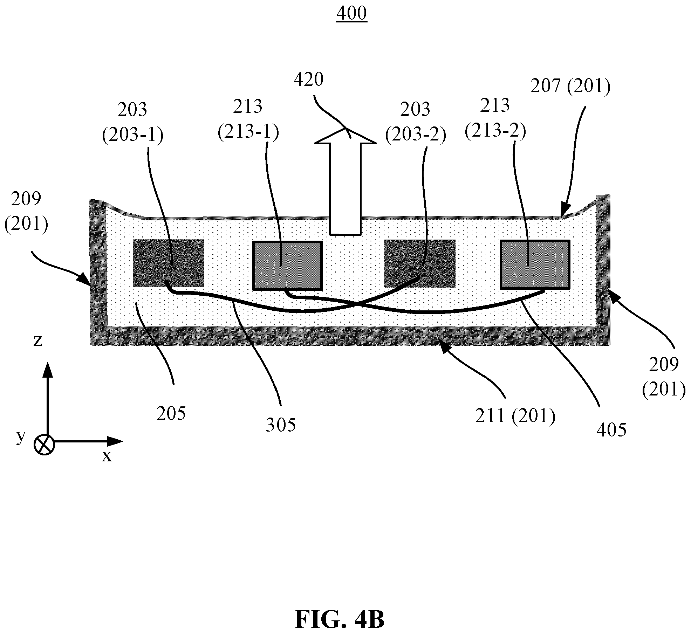

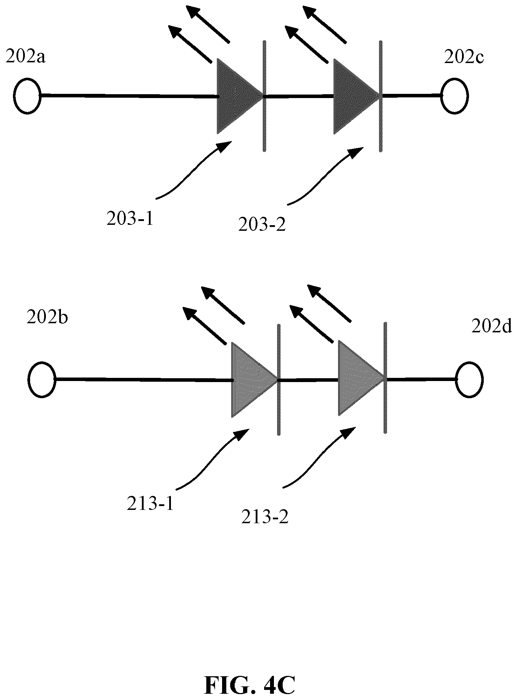

FIGs. 4A and 4B illustrate schematic diagrams of a white LED package 400, according to an embodiment of the present disclosure. FIG. 4A illustrates a top view (e.g., an x-y sectional view) of the white LED package 400, and FIG. 4B illustrates a side view (e.g., an x-z sectional view) of the white LED package 400. FIG. 4C illustrates driving circuits of the white LED package 400, according to an embodiment of the present disclosure. The white LED package 400 shown in FIGs. 4A-4C may include elements, structures, and/or functions that are the same as or similar to those included in the white LED package 200 shown in FIGs. 2A-2C or the white LED package 300 shown in FIGs. 3A-3C. Descriptions of the same or similar elements, structures, and/or functions can refer to the above descriptions rendered in connection with FIGs. 2A-2C or FIGs. 3A-3C.

As shown in FIGs. 4A and 4B, the white LED package 400 may include the package housing (or package wall) 201, the two blue LEDs 203-1 and 203-2 (collectively referred to as 203), two red LEDs 213-1 and 213-2 (collectively referred to as 213), and the green phosphor filler 205. The white LED package 400 may also include the electrodes 202a-202d that are electrically connected to respective LED driving circuits. The red light output from the red LED 213, the blue light output from the blue LEDs 203, and the green light output from the green phosphor filler 205 may be mixed to generate a white light 420.

In some embodiments, the two blue LEDs 203 and the two red LEDs 213 may be aligned along a same row or line (e.g., in the x-y plane). In some embodiments, the two blue LEDs 203 and the two red LEDs 213 may be arranged in an alternating pattern (or interleaving configuration), as shown in FIG. 4A. In some embodiments, the sizes of the red LEDs 213 may be the same, and the sizes of the blue LEDs 203 may be the same. In some embodiments, the size of each red LED 213 may be substantially the same as the size of each blue LED 203. In some embodiments, the size of each red LED 213 may be different from the size of each blue LED 203. The blue LED 203-1 and the blue LED 203-2 may be electrically connected to one another via the connection wire (referred to as a first connection wire) 305. The red LED 213-1 and the red LED 213-2 may be electrically connected to one another via a second, different connection wire 405. The blue LEDs 203 and the red LEDs 213 may be individually or independently driven, e.g., via the controller 250. For example, the two electrically connected blue LED 203-1 and blue LED 203-2 may be driven in series, via a first driving circuit, and the two electrically connected red LED 213-1 and red LED 213-2 may be driven in series, via a second, different driving circuit. The driving currents of the blue LEDs 203 and the red LEDs 213 may be individually or independently adjustable. Thus, the ratio of the red light output from the red LEDs 213, the blue light output from the blue LEDs 203, and the green light output from the green phosphor filler 205 in the white light 420 may be adjustable. Accordingly, a color (e.g., white point) of the white light 420 output from the white LED package 400 may be adjustable.

For example, as shown in FIG. 4C, the first electrode 202a may be the anode of the blue LED 203-1, and the third electrode 202c may be the cathode of the blue LED 203-2, with the cathode of the blue LED 203-1 electrically connected to the anode of the blue LED 203-2. The first electrode 202a and the third electrode 202c may be electrically connected to the first driving circuit for driving the blue LEDs 203. The second electrode 202b may be the anode of the red LED 213-1, and the fourth electrode 202d may be the cathode of the red LED 213-2, with the cathode of the red LED 213-1 electrically connected to the anode of the red LED 213-2. The second electrode 202b and the fourth electrode 202d may be electrically connected to the second driving circuit for driving the red LEDs 213. In some embodiments, the cathode (e.g., third electrode 202c) of the blue LED 203-2 and the cathode (e.g., fourth electrode 202d) of the red LED 213-2 may be electrically connected, whereas the anode (e.g., first electrode 202a) of the blue LED 203-1 and the anode (e.g., second electrode 202b) of the red LED 213-1 may be separately connected to different driving circuits.

In some embodiments, the concentration of the green phosphor filler 205 may be adjustable, through which the ratio of the red light output from the red LEDs 213, the blue light output from the blue LEDs 203, and the green light output from the green phosphor filler 205 in the white light 420 may be adjustable. Accordingly, a color (e.g., white point) of the white light 420 output from the white LED package 400 may be adjustable.

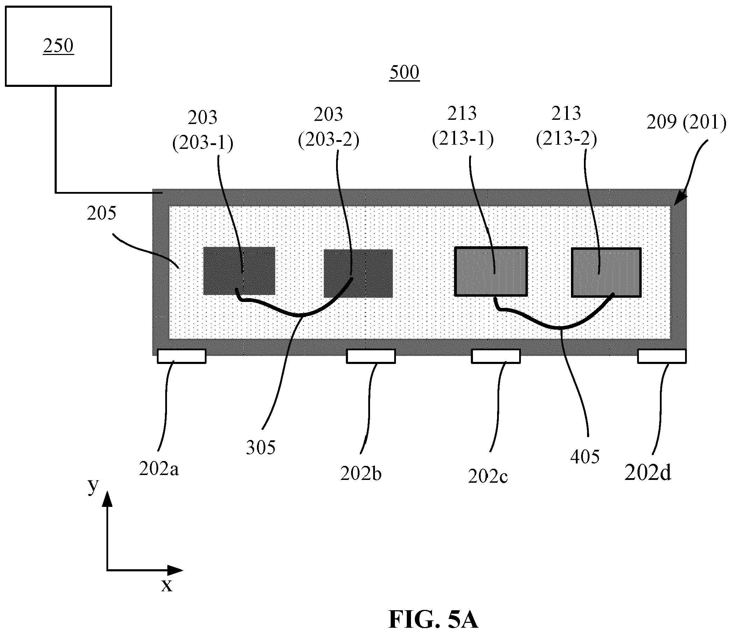

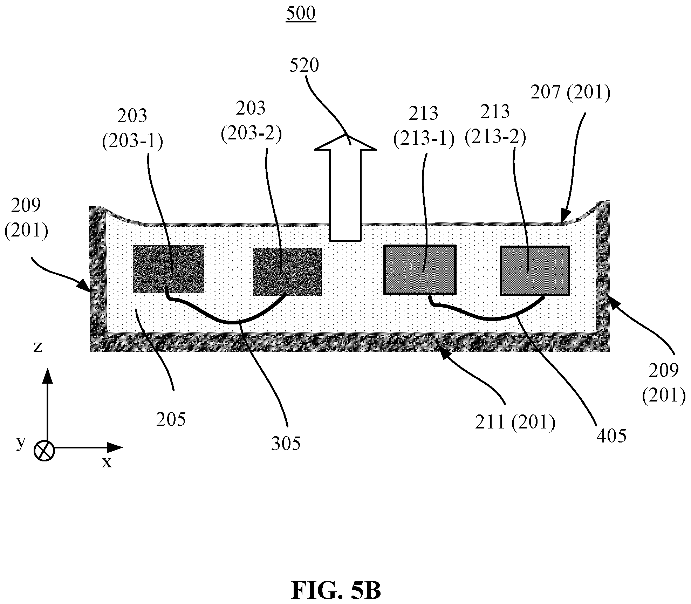

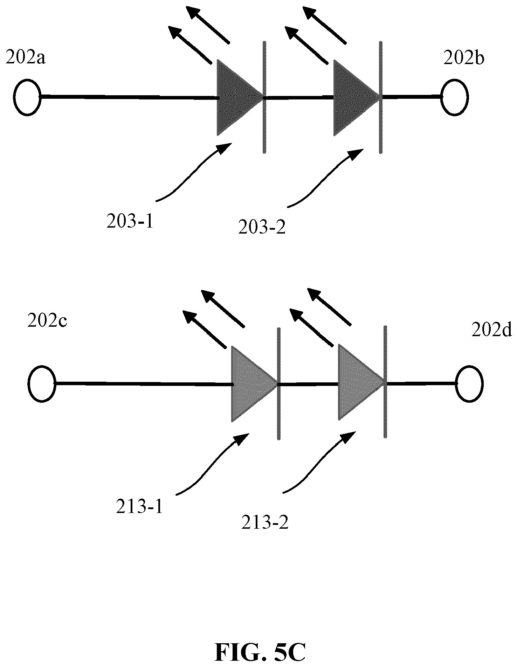

FIGs. 5A and 5B illustrate schematic diagrams of a white LED package 500, according to an embodiment of the present disclosure. FIG. 5A illustrates a top view (e.g., an x-y sectional view) of the white LED package 500, and FIG. 5B illustrates a side view (e.g., an x-z sectional view) of the white LED package 500. FIG. 5C illustrates driving circuits of the white LED package 500, according to an embodiment of the present disclosure. The white LED package 500 shown in FIGs. 5A-5C may include elements, structures, and/or functions that are the same as or similar to those included in the white LED package 200 shown in FIGs. 2A-2C, the white LED package 300 shown in FIGs. 3A-3C, or the white LED package 400 shown in FIGs. 4A-4C. Descriptions of the same or similar elements, structures, and/or functions can refer to the above descriptions rendered in connection with FIGs. 2A-2C, FIGs. 3A-3C, or FIGs. 4A-4C.

As shown in FIGs. 5A and 5B, the white LED package 500 may include the package housing (or package wall) 201, the two blue LEDs 203-1 and 203-2 (collectively referred to as 203), the two red LEDs 213-1 and 213-2 (collectively referred to as 213), and the green phosphor filler 205. The two blue LEDs 203, the two red LEDs 213, and the green phosphor filler 205 may be enclosed by the package housing 201. The white LED package 500 may also include the electrodes 202a-202d that are electrically connected to respective LED driving circuits. The two blue LEDs 203 and the two red LEDs 213 may be aligned along a same row or line. The blue LED 203-1 and the blue LED 203-2 may be electrically connected to one another via the first connection wire 305. The red LED 213-1 and the red LED 213-2 may be electrically connected to one another via the second connection wire 405. Different from the white LED package 400 shown in FIGs. 4A-4C, in the embodiment shown in FIGs. 5A and 5B, the two blue LEDs 203 may be arranged side by side, and the two red LEDs 213 may be arranged side by side. The red light output from the red LEDs 213, the blue light output from the blue LEDs 203, and the green light output from the green phosphor filler 205 may be mixed to generate a white light 520 that exits the white LED package 500 through the light emission window 207.

Similar to the white LED package 400 shown in FIGs. 4A-4C, the two electrically connected blue LED 203-1 and blue LED 203-2 may be driven in series, via the first driving circuit, and the two electrically connected red LED 213-1 and red LED 213-2 may be driven in series, via the second driving circuit, as shown in FIG. 5C. The driving currents of the blue LEDs 203 and the red LEDs 213 may be individually or independently adjustable. Thus, the ratio of the red light output from the red LEDs 213, the blue light output from the blue LEDs 203, and the green light output from the green phosphor filler 205 in the white light 520 may be adjustable. Accordingly, a color (e.g., white point) of the white light 520 output from the white LED package 500 may be adjustable.

For example, in the embodiment shown in FIG. 5C, the first electrode 202a may be the anode of the blue LED 203-1, and the second electrode 202b may be the cathode of the blue LED 203-2, with the cathode of the blue LED 203-1 electrically connected to the anode of the blue LED 203-2. The first electrode 202a and the second electrode 202b may be electrically connected to the first driving circuit for the blue LEDs 203. The third electrode 202c may be the anode of the red LED 213-1, and the fourth electrode 202d may be the cathode of the red LED 213-2, with the cathode of the red LED 213-1 electrically connected to the anode of the red LED 213-2. The third electrode 202c and the fourth electrode 202d may be electrically connected to the second driving circuit. In some embodiments, the cathode (e.g., second electrode 202b) of the blue LED 203-2 and the cathode (e.g., fourth electrode 202d) of the red LED 213-2 may be electrically connected, whereas the anode (e.g., first electrode 202a) of the blue LED 203-1 and the anode (e.g., third electrode 202c) of the red LED 213-1 may be separately connected to different driving circuits.

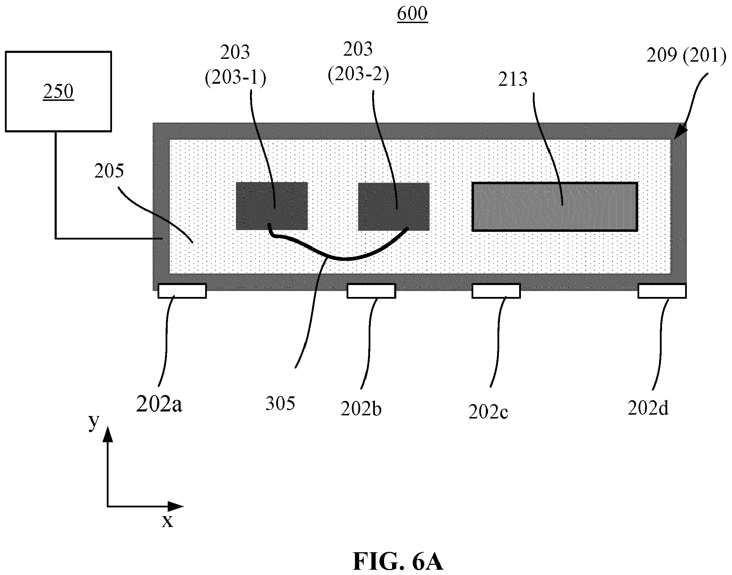

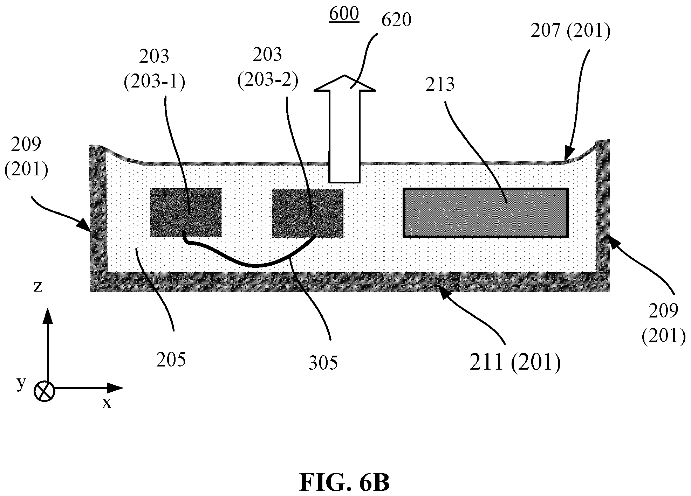

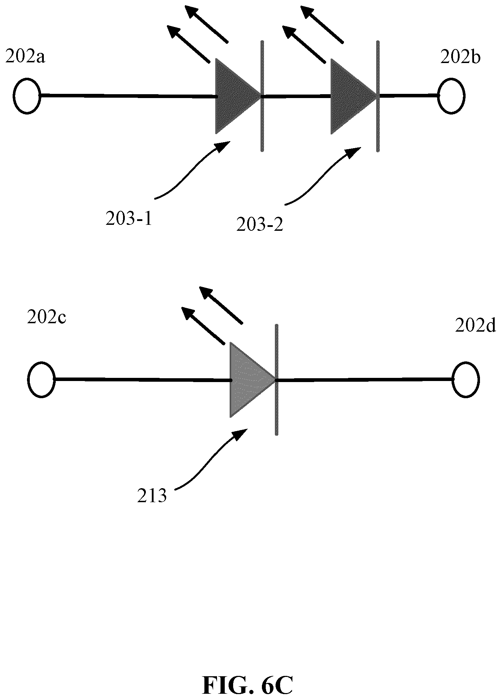

FIGs. 6A and 6B illustrate schematic diagrams of a white LED package 600, according to an embodiment of the present disclosure. FIG. 6A illustrates a top view (e.g., an x-y sectional view) of the white LED package 600, and FIG. 6B illustrates a side view (e.g., an x-z sectional view) of the white LED package 600. FIG. 6C illustrates driving circuits of the white LED package 600, according to an embodiment of the present disclosure. The white LED package 600 shown in FIGs. 6A-6C may include elements, structures, and/or functions that are the same as or similar to those included in the white LED package 200 shown in FIGs. 2A-2C, the white LED package 300 shown in FIGs. 3A-3C, the white LED package 400 shown in FIGs. 4A-4C, or the white LED package 500 shown in FIGs. 5A-5C. Descriptions of the same or similar elements, structures, and/or functions can refer to the above descriptions rendered in connection with FIGs. 2A-2C, FIGs. 3A-3C, FIGs. 4A-4C, or FIGs. 5A-5C.

As shown in FIGs. 6A and 6B, the white LED package 600 may include the package housing (or package wall) 201, the two blue LEDs 203-1 and 203-2 (collectively referred to as 203), the red LED 213, and the green phosphor filler 205. The blue LED 203-1 and the blue LED 203-2 may be electrically connected to one another via the first connection wire 305. The two blue LEDs 203, the red LED 213, and the green phosphor filler 205 may be enclosed by the package housing 201. The white LED package 600 may also include the electrodes 202a-202d that are electrically connected to respective LED driving circuits.

In some embodiments, the two blue LEDs 203 and the red LED 213 may be aligned along a same row or line. Different from the white LED package 300 shown in FIGs. 3A-3C, in the embodiment shown in FIGs. 6A and 6B, the two blue LEDs 203 may be arranged side by side, and the red LED 213 may be disposed at a side of the two blue LEDs 203, rather than being disposed between the two blue LEDs 203 as shown in FIG. 3A. The red light output from the red LED 213, the blue light output from the blue LEDs 203, and the green light output from the green phosphor filler 205 may be mixed to generate a white light 620 that exits the white LED package 600 through the light emission window 207. Similar to the white LED package 300 shown in FIGs. 3A-3C, the two electrically connected blue LED 203-1 and blue LED 203-2 may be driven in series, via the first driving circuit, and the red LED 213 may be driven separately, via the second driving circuit, as shown in FIG. 6C. The driving currents of the blue LEDs 203 and the red LED 213 may be individually or independently adjustable.

For example, in the embodiment shown in FIG. 6C, the first electrode 202a may be the anode of the blue LED 203-1, and the second electrode 202b may be the cathode of the blue LED 203-2, with the cathode of the blue LED 203-1 electrically connected to the anode of the blue LED 203-2. The first electrode 202a and the second electrode 202b may be electrically connected to the first driving circuit for driving the two blue LEDs 203. The third electrode 202c and the fourth electrode 202d may be the anode and the cathode of the red LED 213, respectively, which may be electrically connected to the second driving circuit for driving the red LED 213. In some embodiments, the cathode (e.g., second electrode 202b) of the blue LED 203-2 and the cathode (e.g., fourth electrode 202d) of the red LED 213 may be electrically connected, whereas the anode (e.g., first electrode 202a) of the blue LED 203-1 and the anode (e.g., third electrode 202c) of the red LED 213 may be separately connected to different driving circuits.

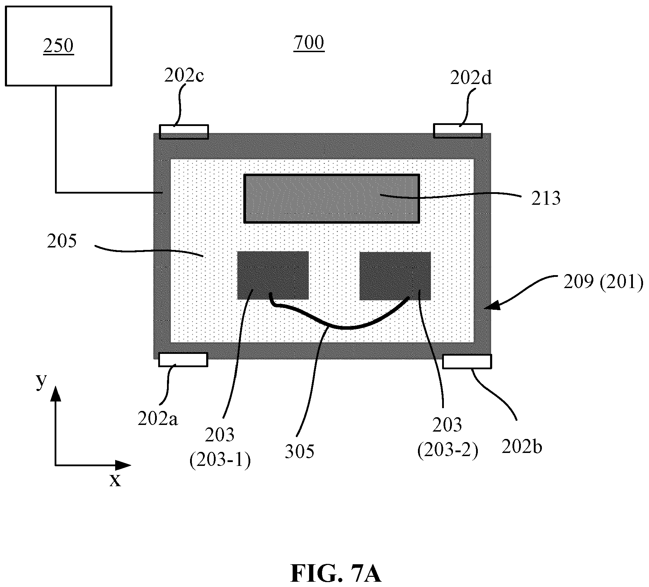

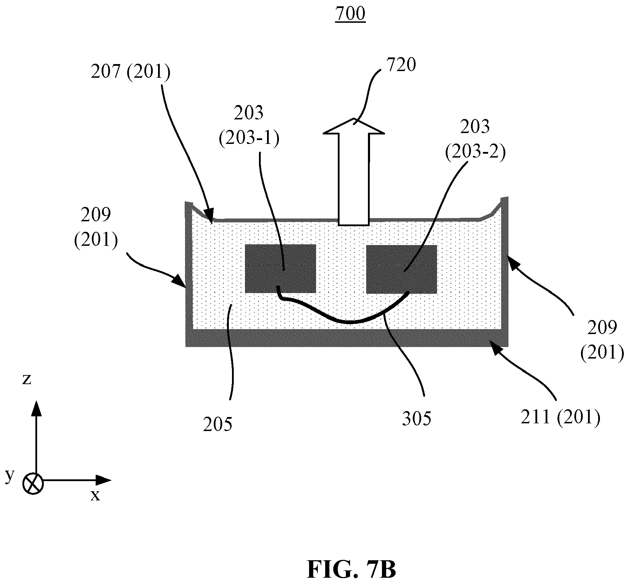

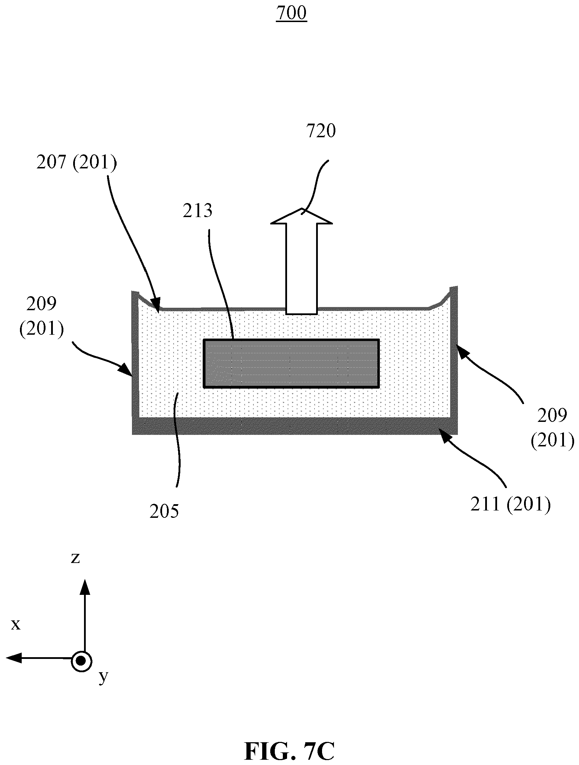

FIGs. 7A-7C illustrate schematic diagrams of a white LED package 700, according to an embodiment of the present disclosure. FIG. 7A illustrates a top view (e.g., an x-y sectional view) of the white LED package 700. FIG. 7B illustrates a side view (e.g., an x-z sectional view) of the white LED package 700, with the viewpoint oriented towards a +y-axis direction, showing the two blue LEDs 203 (the red LED is not visible). FIG. 7C illustrates a side view (e.g., the x-z sectional view) of the white LED package 700, with the viewpoint oriented towards a -y-axis direction, showing the red LED 213 (the blue LEDs 203 are not visible). The white LED package 700 shown in FIGs. 7A-7C may include elements, structures, and/or functions that are the same as or similar to those included in the white LED package 200 shown in FIGs. 2A-2C, the white LED package 300 shown in FIGs. 3A-3C, the white LED package 400 shown in FIGs. 4A-4C, the white LED package 500 shown in FIGs.5A-5C, or the white LED package 600 shown in FIGs. 6A-6C. Descriptions of the same or similar elements, structures, and/or functions can refer to the above descriptions rendered in connection with FIGs. 2A-2C, FIGs. 3A-3C, FIGs. 4A-4C, FIGs. 5A-5C, or FIGs. 6A-6C.

As shown in FIGs. 7A-7C, the white LED package 700 may include the package housing (or package wall) 201, the two blue LEDs 203-1 and 203-2 (collectively referred to as 203), the red LED 213, and the green phosphor filler 205. The blue LED 203-1 and the blue LED 203-2 may be electrically connected to one another via the first connection wire 305. The two blue LEDs 203, the red LED 213, and the green phosphor filler 205 may be enclosed by the package housing 201. The white LED package 700 may also include the electrodes 202a-202d that are electrically connected to respective LED driving circuits.

Different from the white LED package 600 shown in FIGs. 6A-6C, in the embodiment shown in FIGs. 7A-7C, the two blue LEDs 203 may be arranged side by side, aligned along a first row (or line), while the red LED 213 may be aligned in a second row (or line) parallel with the first row (or line). The red LED 213 may have a size that is greater than the blue LED 203, e.g., the size of the red LED 213 may be two times of the size of the blue LED 203. The red light output from the red LED 213, the blue light output from the blue LEDs 203, and the green light output from the green phosphor filler 205 may be mixed to generate a white light 720 that exits the white LED package 700 through the light emission window 207.

Similar to the white LED package 600 shown in FIGs. 6A-6C, in the white LED package 700, the two electrically connected blue LED 203-1 and blue LED 203-2 may be driven in series, via the first driving circuit, and the red LED 213 may be driven separately, via the second driving circuit, as shown in FIG. 7C. The driving currents of the blue LEDs 203 and the red LED 213 may be individually or independently adjustable. The driving circuits of the white LED package 700 may be similar to that shown in FIG. 6C, and the details of the driving circuits of the white LED package 700 may refer to the description of FIG. 6C.

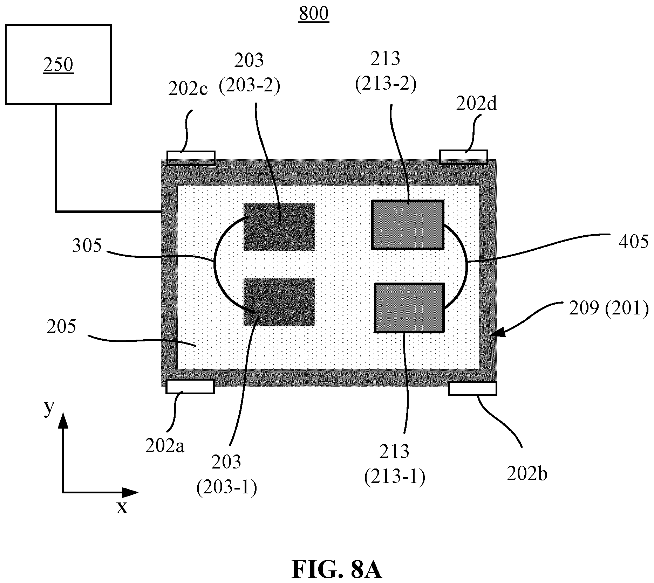

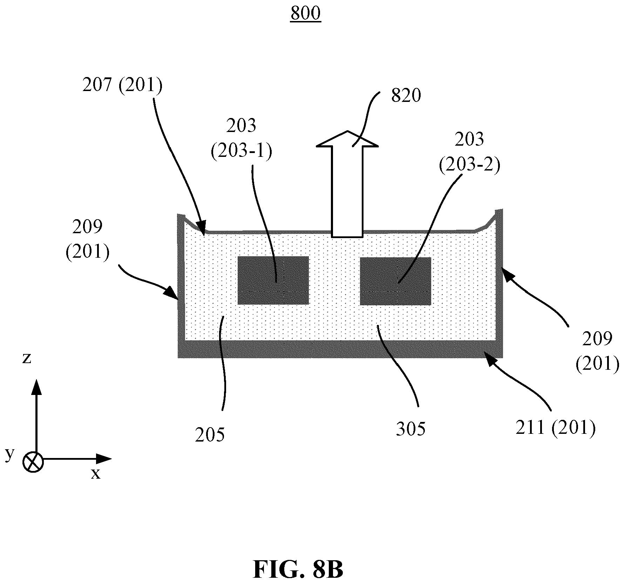

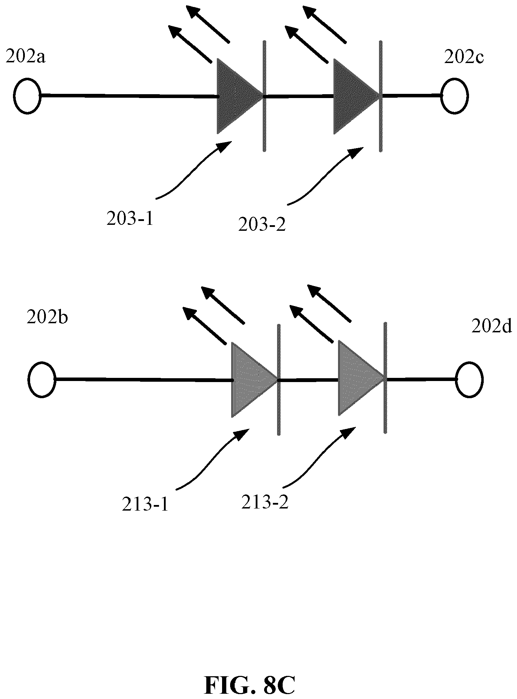

FIGs. 8A and 8B illustrate schematic diagrams of a white LED package 800, according to an embodiment of the present disclosure. FIG. 8A illustrates a top view (e.g., an x-y sectional view) of the white LED package 800, and FIG. 8B illustrates a side view (e.g., an x-z sectional view) of the white LED package 800. FIG. 8C illustrates driving circuits of the white LED package 800, according to an embodiment of the present disclosure. The white LED package 800 shown in FIGs. 8A-8C may include elements, structures, and/or functions that are the same as or similar to those included in the white LED package 200 shown in FIGs. 2A-2C, the white LED package 300 shown in FIGs. 3A-3C, the white LED package 400 shown in FIGs. 4A-4C, the white LED package 500 shown in FIGs. 5A-5C, the white LED package 600 shown in FIGs. 6A-6C, or the white LED package 700 shown in FIGs. 7A-7C. Descriptions of the same or similar elements, structures, and/or functions can refer to the above descriptions rendered in connection with FIGs. 2A-2C, FIGs. 3A-3C, FIGs. 4A-4C, FIGs. 5A-5C, FIGs. 6A-6C, or FIGs. 7A-7C.

As shown in FIGs. 8A and 8B, the white LED package 800 may include the package housing (or package wall) 201, the two blue LEDs 203-1 and 203-2 (collectively referred to as 203), the two red LEDs 213-1 and 213-2 (collectively referred to as 213), and the green phosphor filler 205. The two blue LEDs 203, the two red LEDs 213, and the green phosphor filler 205 may be enclosed by the package housing 201. The white LED package 800 may also include the electrodes 202a-202d that are electrically connected to respective LED driving circuits. The blue LED 203-1 and the blue LED 203-2 may be electrically connected to one another via the first connection wire 305. The red LED 213-1 and the red LED 213-2 may be electrically connected to one another via the second connection wire 405. The two blue LEDs 203 may be aligned along a first row (or line), and the two red LEDs 213 may be aligned along a second row or line.

Different from the white LED package 500 shown in FIGs. 5A and 5B (in the top view of FIG. 5A, the two blue LEDs 203 and the two red LEDs 213 are aligned along a same line or row), in the embodiment shown in FIGs. 8A and 8B, the two blue LEDs 203 may be arranged side by side, aligned along a first row (or line), while the two red LED 213 may be arranged side by side, aligned along a second row (or line) parallel with the first row (or line). In some embodiments, the red LED 213 may have a size that is substantially the same as the blue LED 203.

Similar to the white LED package 500 shown in FIGs. 5A-5C, in the white LED package 800, as shown in FIG. 8C, the two electrically connected blue LED 203-1 and blue LED 203-2 may be driven in series, via the first driving circuit, and the two electrically connected red LED 213-1 and red LED 213-2 may be driven in series, via the second driving circuit. The driving currents of the blue LEDs 203 and the red LEDs 213 may be individually or independently adjustable. For example, in the embodiment shown in FIG. 8C, the first electrode 202a may be the anode of the blue LED 203-1, and the third electrode 202c may be the cathode of the blue LED 203-2, with the cathode of the blue LED 203-1 electrically connected to the anode of the blue LED 203-2. The first electrode 202a and the third electrode 202c may be electrically connected to the first driving circuit for the blue LEDs 203. The second electrode 202b may be the anode of the red LED 213-1, and the fourth electrode 202d may be the cathode of the red LED 213-2, with the cathode of the red LED 213-1 electrically connected to the anode of the red LED 213-2. The second electrode 202b and the fourth electrode 202d may be electrically connected to the second driving circuit. In some embodiments, the cathode (e.g., third electrode 202c) of the blue LED 203-2 and the cathode (e.g., fourth electrode 202d) of the red LED 213-2 may be electrically connected, whereas the anode (e.g., first electrode 202a) of the blue LED 203-1 and the anode (e.g., second electrode 202b) of the red LED 213-1 may be separately connected to different driving circuits. The red light output from the red LEDs 213, the blue light output from the blue LEDs 203, and the green light output from the green phosphor filler 205 may be mixed to generate a white light 820 that exits the white LED package 800 through the light emission window 207.

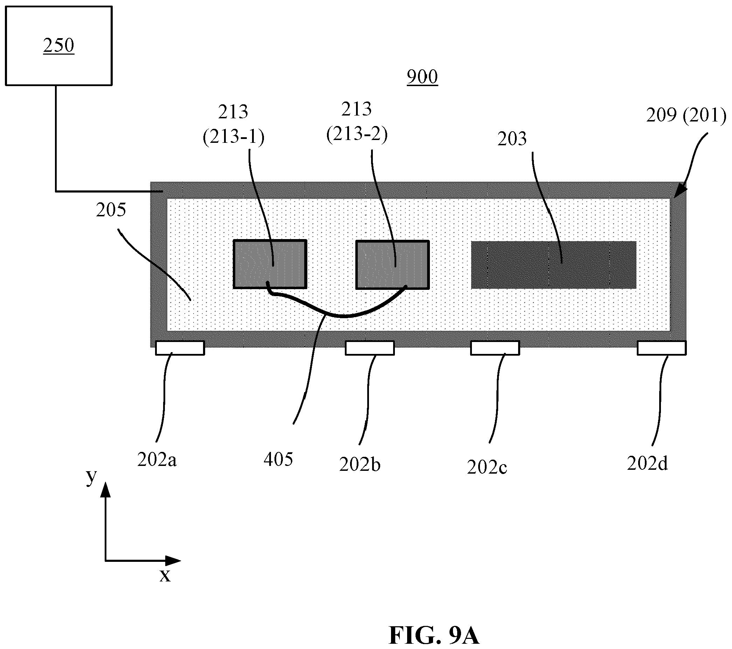

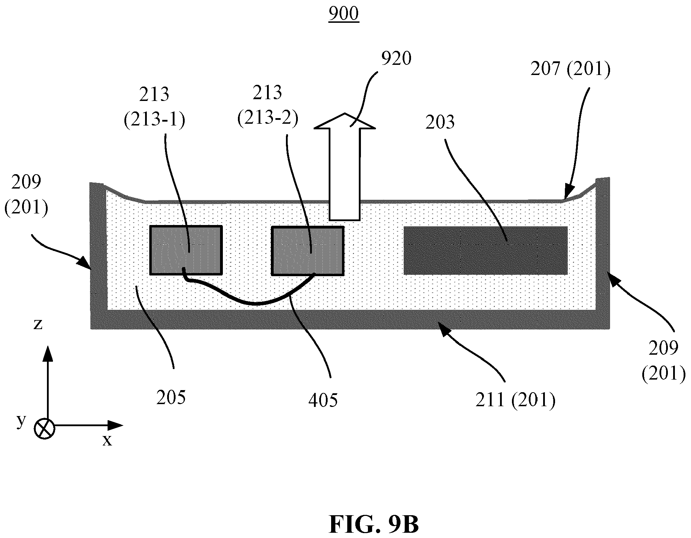

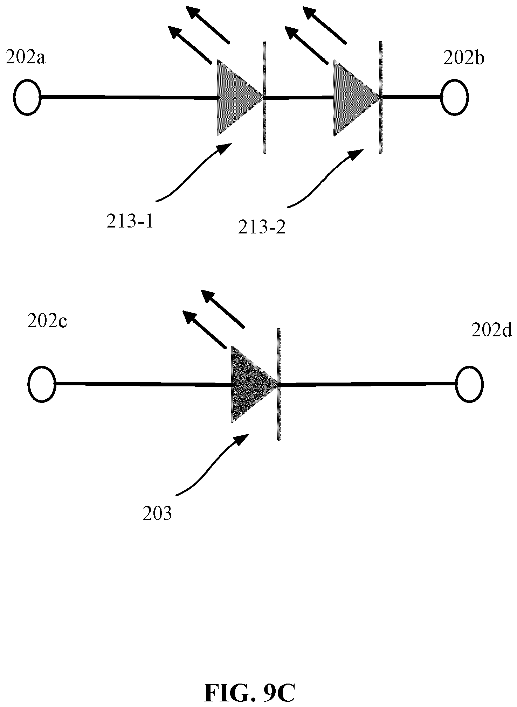

FIGs. 9A and 9B illustrate schematic diagrams of a white LED package 900, according to an embodiment of the present disclosure. FIG. 9A illustrates a top view (e.g., an x-y sectional view) of the white LED package 900, and FIG. 9B illustrates a side view (e.g., an x-z sectional view) of the white LED package 900. FIG. 9C illustrates driving circuits of the white LED package 900, according to an embodiment of the present disclosure. The white LED package 900 shown in FIGs. 9A-9C may include elements, structures, and/or functions that are the same as or similar to those included in the white LED package 200 shown in FIGs. 2A-2C, the white LED package 300 shown in FIGs. 3A-3C, the white LED package 400 shown in FIGs. 4A-4C, the white LED package 500 shown in FIGs. 5A-5C, the white LED package 600 shown in FIGs. 6A-6C, the white LED package 700 shown in FIGs. 7A-7C, or the white LED package 800 shown in FIGs. 8A-8C. Descriptions of the same or similar elements, structures, and/or functions can refer to the above descriptions rendered in connection with FIGs. 2A-2C, FIGs. 3A-3C, FIGs. 4A-4C, FIGs. 5A-5C, FIGs. 6A-6C, FIGs. 7A-7C, or FIGs. 8A-8C.

As shown in FIGs. 9A and 9B, the white LED package 900 may include the package housing (or package wall) 201, the blue LED 203, the two red LED 213-1 and 213-2 (collectively referred to as 213), and the green phosphor filler 205. The red LED 213-1 and the red LED 213-2 may be electrically connected to one another via the second connection wire 405. The blue LED 203, the two red LEDs 213, and the green phosphor filler 205 may be enclosed by the package housing 201. The white LED package 900 may also include the electrodes 202a-202d that are electrically connected to respective LED driving circuits.

The blue LED 203 and the two red LEDs 213 may be aligned along a same row or line. In the embodiment shown in FIGs. 9A and 9B, the two red LEDs 213 may be arranged side by side, and the blue LED 203 and the two red LEDs 213 may be arranged side by side. For example, the red LED 213-2 may be disposed between the red LED 213-1 and the blue LED 203. That is, the blue LED 203 may be disposed at a side of the two red LEDs 213. In some embodiments, although not shown, the blue LED 203 between the red LED 213-2 and the red LED 213-1. In some embodiments, the blue LED 203 may have a size that is greater than the red LED 213, e.g., the size of the blue LED 203 may be two times of the size of the red LED 213. The red light output from the red LEDs 213, the blue light output from the blue LED 203, and the green light output from the green phosphor filler 205 may be mixed to generate a white light 920 that exits the white LED package 900 through the light emission window 207.

The blue LED 203 and the two red LEDs 213 may be individually or independently driven, e.g., via the controller 250. As shown in FIG. 9C, the two electrically connected red LED 213-1 and red LED 213-2 may be driven in series, via the second driving circuit, and the blue LED 203 may be driven separately, via the first driving circuit. The driving currents of the blue LEDs 203 and the red LED 213 may be individually or independently adjustable. For example, in the embodiment shown in FIG. 9C, the first electrode 202a may be the anode of the red LED 213-1, and the second electrode 202b may be the cathode of the red LED 213-2, with the cathode of the red LED 213-1 electrically connected to the anode of the red LED 213-2. The first electrode 202a and the second electrode 202b may be electrically connected to the second driving circuit for driving the two red LEDs 213. The third electrode 202c and the fourth electrode 202d may be the anode and the cathode of the blue LED 203, respectively, which may be electrically connected to the first driving circuit. In some embodiments, the cathode (e.g., second electrode 202b) of the red LED 213-2 and the cathode (e.g., fourth electrode 202d) of the blue LED 203 may be electrically connected, whereas the anode (e.g., first electrode 202a) of the red LED 213-1 and the anode (e.g., third electrode 202c) of the blue LED 203 may be separately connected to different driving circuits.

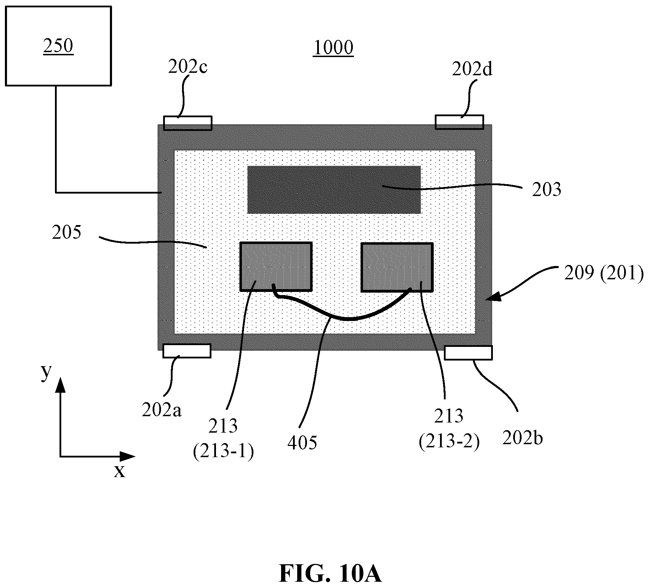

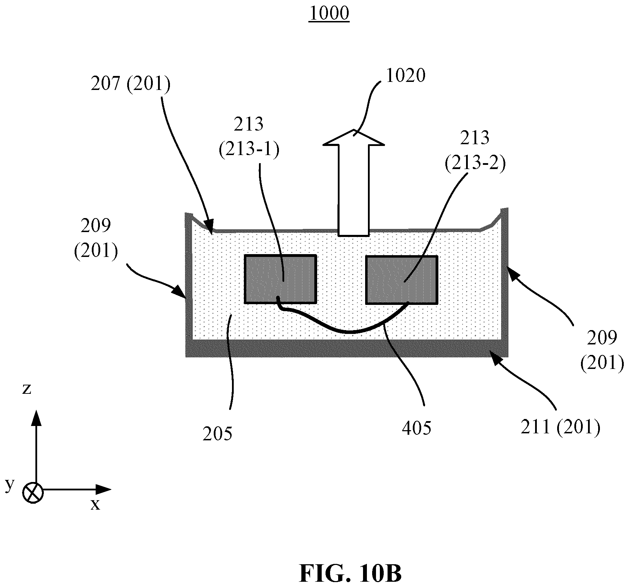

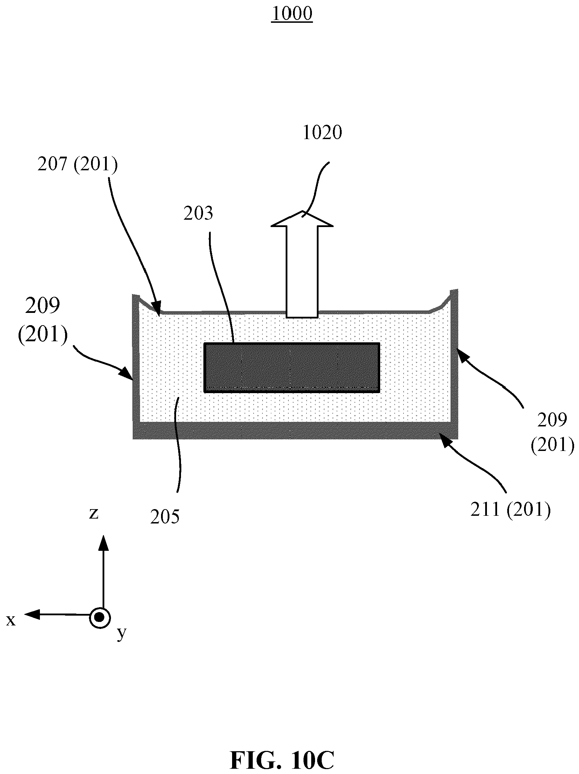

FIGs. 10A-10C illustrate schematic diagrams of a white LED package 1000, according to an embodiment of the present disclosure. FIG. 10A illustrates a top view (e.g., an x-y sectional view) of the white LED package 1000. FIG. 10B illustrates a side view (e.g., an x-z sectional view) of the white LED package 1000, with the viewpoint oriented towards a +y-axis direction. FIG. 10C illustrates a side view (e.g., the x-z sectional view) of the white LED package 1000, with the viewpoint oriented towards a -y-axis direction. The white LED package 1000 shown in FIGs. 10A-10C may include elements, structures, and/or functions that are the same as or similar to those included in the white LED package 200 shown in FIGs. 2A-2C, the white LED package 300 shown in FIGs. 3A-3C, the white LED package 400 shown in FIGs. 4A-4C, the white LED package 500 shown in FIGs. 5A-5C, the white LED package 600 shown in FIGs. 6A-6C, the white LED package 700 shown in FIGs. 7A-7C, the white LED package 800 shown in FIGs. 8A-8C, or the white LED package 900 shown in FIGs. 9A-9C. Descriptions of the same or similar elements, structures, and/or functions can refer to the above descriptions rendered in connection with FIGs. 2A-2C, FIGs. 3A-3C, FIGs. 4A-4C, FIGs. 5A-5C, FIGs. 6A-6C, FIGs. 7A-7C, FIGs. 8A-8C, or FIGs. 9A-9C.

As shown in FIGs. 10A-10C, the white LED package 1000 may include the package housing (or package wall) 201, the blue LED 203, the two red LED 213-1 and 213-2 (collectively referred to as 213), and the green phosphor filler 205. The red LED 213-1 and the red LED 213-2 may be electrically connected to one another via the second connection wire 405. The blue LED 203, the two red LEDs 213, and the green phosphor filler 205 may be enclosed by the package housing 201. The white LED package 1000 may also include the electrodes 202a-202d that are electrically connected to respective LED driving circuits.

Different from the white LED package 900 shown in FIGs. 9A-9C, in the embodiment shown in FIGs. 10A-10C, the two red LEDs 213 may be arranged side by side, aligned along a first row (or line), while the blue LED 203 may be aligned in a second row (or line) parallel with the first row (or line). In some embodiments, the blue LED 203 may have a size that is greater than the red LED 213, e.g., the size of the blue LED 203 may be two times of the size of the red LED 213. The red light output from the red LEDs 213, the blue light output from the blue LED 203, and the green light output from the green phosphor filler 205 may be mixed to generate a white light 1020 that exits the white LED package 1000 through the light emission window 207.

Similar to the white LED package 900 shown in FIGs. 9A-9C, in the white LED package 1000, the two electrically connected red LED 213-1 and red LED 213-2 may be driven in series, via the second driving circuit, and the blue LED 203 may be driven separately, via the first driving circuit. The driving currents of the red LED 213 and the blue LED 203 may be individually or independently adjustable. The driving circuits of the white LED package 1000 may be similar to that shown in FIG. 9C, and the details of the driving circuits of the white LED package 1000 may refer to the description of FIG. 9C.

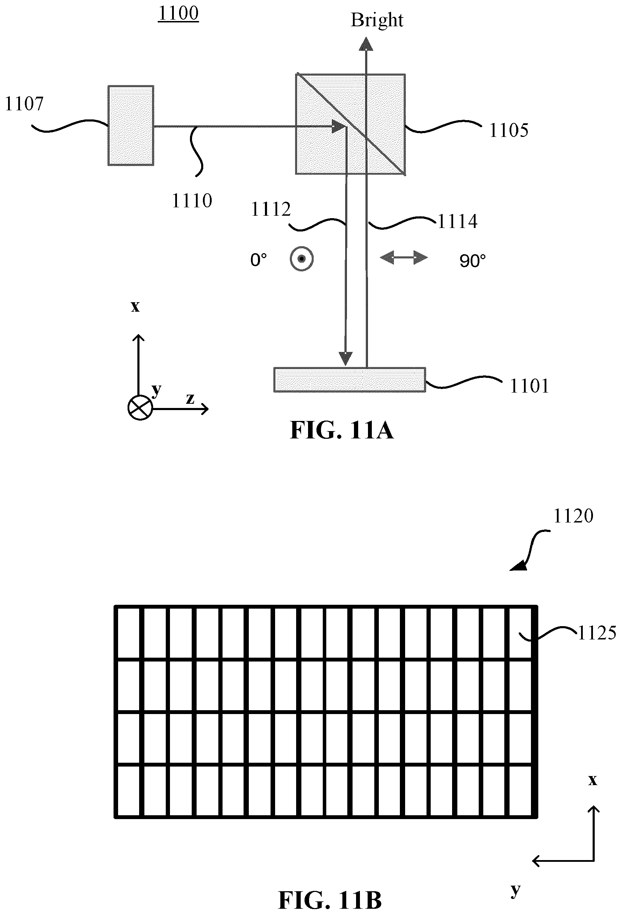

FIG. 11A illustrates a schematic diagram of a display system 1100, according to an embodiment of the present disclosure. The display system 1100 may include one or more disclosed white LED packages. As shown FIG. 11A, the display system 1100 may include a backlight module 1107, a reflective display panel 1101, and a polarizing component 1105. For discussion purposes, the polarizing component 1105 is shown as including a polarization beam splitter ("PBS") (also referred to as 1105 for discussion purposes). The backlight module 1107 may output a backlight 1110 toward the PBS 1105. The backlight 1110 may be polarized and reflected as a backlight 1112 toward the reflective display panel 1101. The reflective display panel 1101 may modulate and reflect the backlight 1112 as an image light 1114 back to the PBS 1105. The image light 1114 may have different polarization depending on the modulation of the backlight 1112 provided by the reflective display panel 1101. The PBS 1105 may substantially transmit or block the image light 1114 depending on the polarization state of the image light 1114. For discussion purposes, FIG. 11A shows that the PBS 1105 reflects a linearly polarized light that is polarized in 0° (e.g., in a y-axis direction) and transmits a linearly polarized light that is polarized in 90° (e.g., in a z-axis direction), the backlight 1112 is a linearly polarized light that is polarized in 0° (e.g., in the y-axis direction), and the image light 1114 may be a linearly polarized light that is polarized in 90° (e.g., in the z-axis direction). Thus, the PBS 1105 may substantially transmit the image light 1114.

FIG. 11B illustrates an x-y sectional view of an illuminator 1120 that may be included in the backlight module 1107 shown in FIG. 11A, according to an embodiment of the present disclosure. As shown in FIGs. 11A and 11B, the backlight module 1107 may include the illuminator 1120, and a plurality of optical elements (not shown) coupled with the illuminator 1120. The plurality of optical elements (not shown) may be configured to condition a backlight output from the illuminator 1120 into the backlight 1110 propagating toward the PBS 1105. The illuminator 1120 may be an arrayed light source panel including a plurality of light sources 1125. Each light source 1125 may include an embodiment of the disclosed white LED packages. In some embodiments, the plurality of light sources 1125 may be individually addressable, e.g., via the controller 250, to provide dynamic zonal brightness control, and improved display performance and power budget.

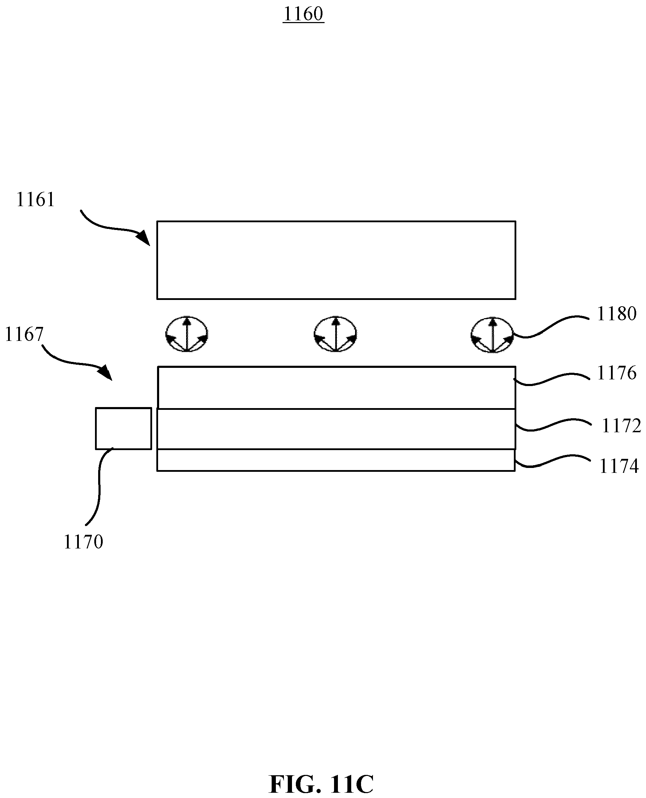

FIG. 11C illustrates a schematic diagram of a display system 1160, according to an embodiment of the present disclosure. The display system 1160 may include one or more disclosed white LED packages. As shown FIG. 11C, the display system 1160 may include a backlight unit ("BLU") 1167 and a liquid crystal display ("LCD") panel 1161. The BLU 1167 may be configured to illuminate the LCD panel 1161. The BLU 1167 may include a light source 1170, a light guide plate 1172, a reflector sheet 1174, and an optical film stack 1176. The light source 1170 may be disposed between the reflector sheet 1174 and the optical film stack 1176, and the optical film stack 1176 may be disposed between the light guide plate 1172 and the LCD panel 1161. The light source 1170 may include one or more disclosed white LED packages. For discussion purposes, the display system 1160 is shown as an edge-lit LCD system, in which the light source 1170 is disposed at an edge of the light guide plate 1172. The light source 1170 may be configured to output a backlight (e.g., a white light, not shown) toward the light guide plate 1172, and the light guide plate 1172 may propagate the backlight toward the optical film stack 1176. The optical film stack 1176 may be configured to condition the backlight received from the light guide plate 1172 into a desirable backlight 1180, which illuminates the LCD panel 1161. The optical film stack 1176 may include one or more optical films arranged in a stack, e.g., a diffuser film, a first prism film, and a second prism film arranged in a stack.

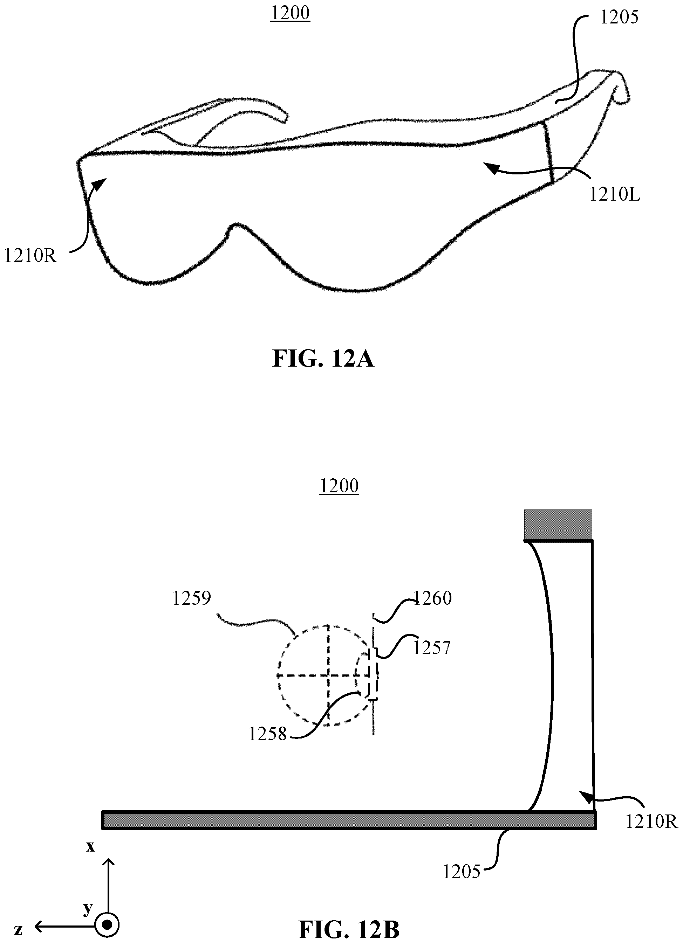

FIG. 12A illustrates a schematic diagram of an artificial reality system 1200, according to an embodiment of the present disclosure. The artificial reality system 1200 may present VR, AR, and/or MR content to a user, such as images, video, audio, or a combination thereof. In some embodiments, the artificial system 1200 may be configured to be worn on a head of a user (e.g., by having the form of spectacles or eyeglasses, as shown in FIG. 12A), or to be included as part of a helmet that is worn by the user. In some embodiments, the artificial system 1200 may be referred to as a head-mounted display. In some embodiments, the artificial system 1200 may be configured for placement in proximity of an eye or eyes of the user at a fixed location in front of the eye(s), without being mounted to the head of the user. For example, the artificial system 1200 may be mounted in a vehicle, such as a car or an airplane, at a location in front of an eye or eyes of the user.

For discussion purposes, FIG. 12A shows that the artificial reality system 1200 includes a frame 1205 configured to mount to a head of a user, and left-eye and right-eye display systems 1210L and 1210R mounted to the frame 1205. The frame 1205 is merely an example structure to which various components of the artificial reality system 1200 may be mounted. Other suitable type of fixtures may be used in place of or in combination with the frame 1205. The left-eye and right-eye display systems 1210L and 1210R may be customized to a variety of shapes and sizes to conform to different styles of the frame 1205.

FIG. 12B is a cross-sectional view of half of the artificial reality system 1200 shown in FIG. 12A according to an embodiment of the present disclosure. For illustrative purposes, FIG. 12B shows the cross-sectional view associated with the right-eye display system 1210R. Referring to FIGs. 12A and 12B, each of the left-eye display system 1210L and the right-eye display system 1210R may be configured to project a virtual image through an eye-box region 1260 of the system 1200. Each of the left-eye display system 1210L and the right-eye display system 1210R may include a backlight module, a display panel, and a plurality of suitable optical elements. The backlight module may include an illuminator, which may be an arrayed light source panel including a plurality of disclosed white LED packages. In some embodiments, the illuminator may provide dynamic zonal brightness control, enhancing the display performance and power budget. The eye-box region 1260 is a region in space where an eye 1259 of the user is positioned to perceive the virtual image projected by the left-eye display system 1210L or the right-eye display system 1210R. The eye-box region 1260 may include one or more exit pupils 1257. The left-eye display system 1210L or the right-eye display system 1210R may project the virtual image through the one or more exit pupils 1257, and an eye pupil 1258 may be positioned at the one or more exit pupils 1257 to perceive the virtual image.

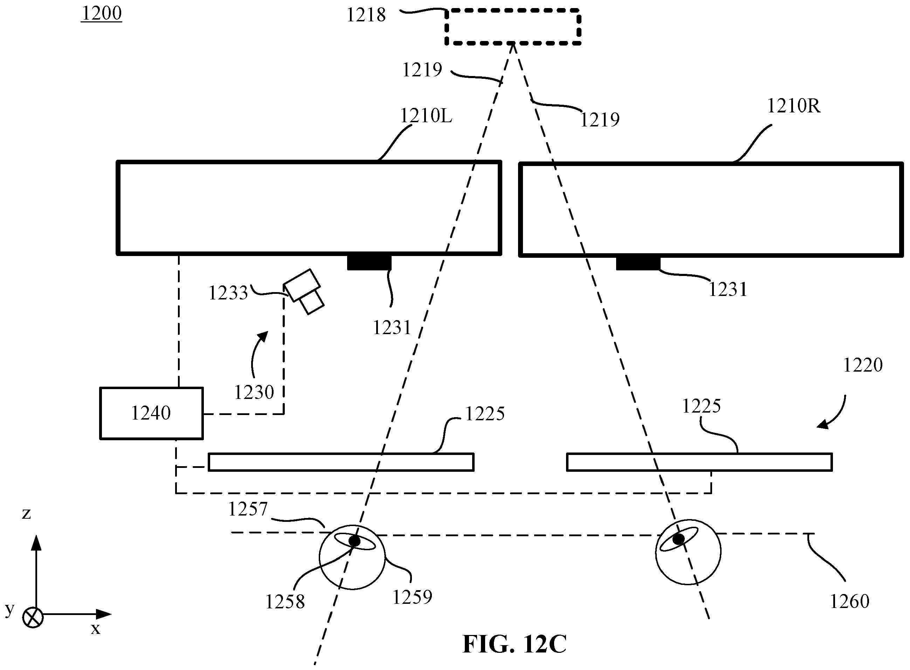

FIG. 12C is a detailed cross-sectional view of the artificial reality system 1200 shown in FIG. 12A, according to an embodiment of the present disclosure. Referring to FIG. 12A and FIG. 12C, each of the left-eye display system 1210L and the right-eye display system 1210R may be configured to project a virtual image through the eye-box region 1260 of the corresponding display system 1210L or 1210R. In some embodiments, each of the left-eye display system 1210L and the right-eye display system 1210R may be an embodiment of the display system 1160 shown in FIG. 11C. For example, each of the left-eye display system 1210L and the right-eye display system 1210R may include a backlight unit and a display panel (e.g., an LCD panel). The display system 1210L or 1210R may display virtual (i.e., computer-generated) images to a user.

In some embodiments, the artificial reality system 1200 may also include a viewing optics assembly 1220, an object tracking system 1230, and a controller 1240 (e.g., a controller similar to the controller 250). The viewing optics assembly 1220 may be arranged between the display system 1210L or 1210R and eyes 1259, and may be configured to guide an image light output from the display system 1210L or 1210R to the eye-box region 1260. The image light may represent a virtual image displayed on the display system 1210L or 1210R. In some embodiments, the viewing optics assembly 1220 may include two lens assemblies 1225 for the left and right eyes 1259, respectively. The object tracking system 1230 may be an eye tracking system and/or face tracking system. The object tracking system 1230 may include an infrared ("IR") light source 1231 configured to emit an IR light to illuminate the eyes 1259 and/or the face. The object tracking system 1230 may also include an optical sensor 1233, such as a camera, configured to receive the IR light reflected by each eye 1259 and generate a tracking signal relating to the eye 1259, such as an image of the eye 1259. In some embodiments, the object tracking system 1230 may also include an IR deflecting element (not shown) configured to deflect the IR light reflected by the eye 1259 toward the optical sensor 1233. The controller 1240 may be communicatively coupled with the display system 1210L or 1210R, the viewing optics assembly 1220, and/or the object tracking system 1230 to control the operations thereof.

In some embodiments, the lens assembly 1225 may be configured to mitigate the accommodation-vergence conflict in the system 1200. For example, the display systems 1210L and 1210R may be synchronized to display respective virtual images including a same virtual object. The virtual objects may be located in different positions in the respective virtual images, or the respective virtual images may show different perspectives of the virtual object. Based on the eye tracking information provided by the eye tracking system 1230, the controller 1240 may determine a vergence depth (dv) of the gaze of the user that verges on a virtual object 1218, based on the gaze point or an estimated intersection of gaze lines 1219 determined by the object tracking system 1230. As shown in FIG. 12C, the gaze lines 1219 may converge or intersect at the distance dv, where the virtual object 1218 is located. The controller 1240 may control the lens assemblies 1225 to adjust the optical power to provide an accommodation that matches the vergence depth (dv) associated with the virtual object 1218, thereby reducing the accommodation-vergence conflict in the system 1200. For example, the controller 1240 may control the lens assembly 1225 to provide an optical power corresponding to a focal plane or an image plane of the display systems 1210L and 1210R that matches with the vergence depth (dv).

The foregoing description of the embodiments of the present disclosure have been presented for the purpose of illustration. It is not intended to be exhaustive or to limit the disclosure to the precise forms disclosed. Persons skilled in the relevant art can appreciate that modifications and variations are possible in light of the above disclosure.

Further, when an embodiment illustrated in a drawing shows a single element, it is understood that the embodiment or an embodiment not shown in the figures but within the scope of the present disclosure may include a plurality of such elements. Likewise, when an embodiment illustrated in a drawing shows a plurality of such elements, it is understood that the embodiment or an embodiment not shown in the figures but within the scope of the present disclosure may include only one such element. The number of elements illustrated in the drawing is for illustration purposes only, and should not be construed as limiting the scope of the embodiment. Moreover, unless otherwise noted, the embodiments shown in the drawings are not mutually exclusive, and they may be combined in any suitable manner. For example, elements shown in one figure/embodiment but not shown in another figure/embodiment may nevertheless be included in the other figure/embodiment. In any optical device disclosed herein including one or more optical layers, films, plates, or elements, the numbers of the layers, films, plates, or elements shown in the figures are for illustrative purposes only. In other embodiments not shown in the figures, which are still within the scope of the present disclosure, the same or different layers, films, plates, or elements shown in the same or different figures/embodiments may be combined or repeated in various manners to form a stack.

Various embodiments have been described to illustrate the exemplary implementations. Based on the disclosed embodiments, a person having ordinary skills in the art may make various other changes, modifications, rearrangements, and substitutions without departing from the scope of the present disclosure. Thus, while the present disclosure has been described in detail with reference to the above embodiments, the present disclosure is not limited to the above described embodiments. The present disclosure may be embodied in other equivalent forms without departing from the scope of the present disclosure. The scope of the present disclosure is defined in the appended claims.

## Claims

1. A light-emitting diode ("LED") package, comprising:
a package housing defining a space;
a first LED disposed with the space defined by the package housing, and configured to emit a first light having a blue wavelength range, wherein the blue wavelength range has a peak wavelength ranging from about 440 nm to about 480 nm;
a second LED disposed within the space defined by the package housing, and configured to emit a second light having a red wavelength range, wherein the red wavelength range has a peak wavelength ranging from about 610 nm to about 680 nm; and
a phosphor filler filling the space and configured to absorb a portion of the first light to emit a third light having a green wavelength range, wherein the green wavelength range has a peak wavelength ranging from about 510 nm to about 570 nm.

2. The LED package of claim 1, wherein the first LED and the second LED are configured to be individually or independently drivable by individual driving circuits.

3. The LED package of claim 2, further comprising a controller configured to individually control driving currents provided by the driving circuits to the first LED and the second LED to adjust a color of an output light of the LED package.

4. The LED package of claim 1, claim 2 or claim 3, wherein a concentration of the phosphor filler is adjustable to adjust a color of an output light of the LED package.

5. The LED package of any one of the preceding claims, further comprising a third LED disposed inside the package housing, and configured to emit the first light having the blue wavelength range, wherein the blue wavelength range has the peak wavelength ranging from about 440 nm to about 480 nm.

6. The LED package of claim 5, wherein the first LED and the third LED are connected in series, and are configured to be drivable by a same driving circuit.

7. The LED package of claim 5 or claim 6, wherein the first LED and the second LED are configured to be individually or independently drivable by individual driving circuits; and preferably,
further comprising a controller configured to individually control driving currents provided by the driving circuits to the first LED and the second LED to adjust a color of an output light of the LED package; and preferably,
wherein the driving currents provided to the first LED and the second LED are the same, or are different.

8. The LED package of claim 5, claim 6 or claim 7, wherein a concentration of the phosphor filler is adjustable to adjust a color of an output light of the LED package.

9. The LED package of any one of claims 5 to 8, wherein the second LED is disposed between the first LED and the third LED.

10. The LED package of any one of claims 5 to 9, wherein the first LED and the third LED are disposed side by side along a first row, the second LED is disposed along a second row, and the second row is parallel with the first row or the same as the first row.

11. The LED package of any one of claims 5 to 9, wherein the first LED, the second LED, and the third LED are disposed side by side along a same row.

12. The LED package of any one of claims 5 to 11, wherein the second LED has a size that is greater than the first LED.

13. The LED package of any one of claims 5 to 12, further comprising a fourth LED disposed inside the package housing, and configured to emit the second light having the red wavelength range with the peak wavelength ranging from about 610 nm to about 680 nm.

14. The LED package of claim 15, wherein one or more selected from:
i. the first LED and the third LED are connected in series and are configured to be drivable by a first driving circuit, and the second LED and the fourth LED are connected in series and are configured to be drivable by a second, different driving circuit, and wherein the LED package further includes a controller configured to individually control driving currents provided by the first and second driving circuits to adjust a color of an output light of the LED package;
ii. the first LED and the third LED are blue LEDs, and the second LED and the fourth LED are red LEDs, and the blue LEDs and the red LEDs are arranged in an alternating pattern;
iii. the first LED and the third LED are arranged side by side along a first row, and the second LED and the fourth LED are arranged side by side along a second row, the second row is parallel with the first row;
iv. the first LED, the second LED, the third LED, and the fourth LED are arranged side by side along a same row.

15. The LED package of any one of claims 1 to 4, further comprising a third LED disposed inside the package housing, and configured to emit the second light having the red wavelength range with the peak wavelength ranging from about 610 nm to about 680 nm.
